(19) Europäisches Patentamt
European Patent Office
Office européen des brevets

(11) **EP 4 276 129 A1**

(12) **EUROPEAN PATENT APPLICATION**
published in accordance with Art. 153(4) EPC

(43) Date of publication:
**15.11.2023 Bulletin 2023/46**

(21) Application number: **21928202.7**

(22) Date of filing: **01.09.2021**

(51) International Patent Classification (IPC):
***C08G 61/12*** *(2006.01)* ***H01L 51/50*** *(2006.01)*
***H01L 51/52*** *(2006.01)*

(52) Cooperative Patent Classification (CPC):
**C08G 61/12; H10K 50/00; H10K 50/80**

(86) International application number:
**PCT/KR2021/011754**

(87) International publication number:
**WO 2022/181908 (01.09.2022 Gazette 2022/35)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **26.02.2021 KR 20210026474**

(71) Applicant: **Lg Chem, Ltd.**
**Seoul 07336 (KR)**

(72) Inventors:
- **KIM, Ji Hoon**
**Daejeon 34122 (KR)**
- **LEE, Jaechol**
**Daejeon 34122 (KR)**
- **WOO, Yu Jin**
**Daejeon 34122 (KR)**
- **KANG, Sungkyoung**
**Daejeon 34122 (KR)**
- **YOO, Seung Jun**
**Daejeon 34122 (KR)**
- **KHIM, Dongyoon**
**Daejeon 34122 (KR)**

(74) Representative: **Hoffmann Eitle**
**Patent- und Rechtsanwälte PartmbB**
**Arabellastraße 30**
**81925 München (DE)**

(54) **POLYMER AND ORGANIC LIGHT-EMITTING DEVICE USING SAME**

(57) The present specification relates to a polymer, and an organic light emitting device using the same.

【FIG. 1】

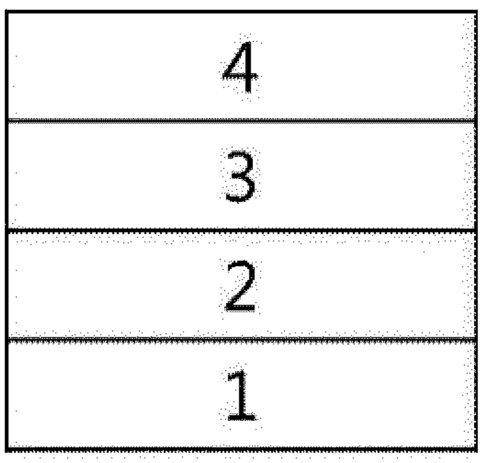


EP 4 276 129 A1

## Description

[Technical Field]

This application claims priority to and the benefits of Korean Patent Application No. 10-2021-0026474, filed with the Korean Intellectual Property Office on February 26, 2021, the entire contents of which are incorporated herein by reference.

The present specification relates to a polymer, and an organic light emitting device formed using the same.

[Background Art]

An organic light emission phenomenon is one of examples converting a current to visible light by an internal process of specific organic molecules. A principle of an organic light emission phenomenon is as follows. When an organic material layer is placed between an anode and a cathode and a current is applied between the two electrodes, electrons and holes are injected to the organic material layer from the cathode and the anode, respectively. The holes and the electrons injected to the organic material layer recombine to form excitons, and light emits when these excitons fall back to the ground state. An organic electroluminescent device using such a principle may be generally formed with a cathode, an anode, and an organic material layer placed therebetween, for example, an organic material layer including a hole injection layer, a hole transfer layer, a light emitting layer, an electron transfer layer and an electron injection layer.

Materials used in an organic light emitting device are mostly pure organic materials or complex compounds in which organic materials and metals form complexes, and may be divided into a hole injection material, a hole transfer material, a light emitting material, an electron transfer material, an electron injection material and the like depending on the application. Herein, as the hole injection material or the hole transfer material, organic materials having a p-type property, that is, organic materials readily oxidized and having an electrochemically stable state when oxidized, are generally used. Meanwhile, as the electron injection material or the electron transfer material, organic materials having an n-type property, that is, organic materials readily reduced and having an electrochemically stable state when reduced, are generally used. As the light emitting material, materials having both a p-type property and an n-type property, that is, materials having a stable form in both oxidized and reduced states, are preferred, and materials having high light emission efficiency converting, when excitons are formed, the excitons to light are preferred.

In addition to the properties described above, it is preferred that materials used in an organic light emitting device additionally have properties as follows.

First, materials used in an organic light emitting device preferably have excellent thermal stability. This is due to joule heating produced by charge migration in the organic light emitting device. NPB (N,N'-di(1-naphthyl)-N,N'-diphenyl-(1,1'-biphenyl)-4,4'-diamine) normally used as a hole transfer layer material currently has a glass transition temperature of 100°C or lower, and has a problem in that it is difficult to use in organic light emitting devices requiring a high current.

Second, in order to obtain a highly efficient organic light emitting device capable of low voltage driving, holes or electrons injected into the organic light emitting device need to be smoothly transferred to a light emitting layer, and at the same time, the injected holes and electrons need to be kept from escaping out of the light emitting layer. For this, materials used in the organic light emitting device need to have proper band gap and HOMO (highest occupied molecular orbital) or LUMO (lowest unoccupied molecular orbital) energy level. PEDOT:PSS (poly(3,4-ethylenedioxythiophene) doped:poly(styrenesulfonic acid)) currently used as a hole transfer material in an organic light emitting device manufactured using a solution coating method has a lower LUMO energy level compared to a LUMO energy level of organic materials used as a light emitting layer material, and therefore, has a problem in manufacturing an organic light emitting device with high efficiency and long lifetime.

In addition thereto, materials used in an organic light emitting device need to have excellent chemical stability, charge mobility, and interfacial properties with electrodes or adjacent layers. In other words, materials used in an organic light emitting device need to undergo less material deformation caused by moisture or oxygen. In addition, by having proper hole or electron mobility, the materials need to maximize exciton formation through balancing hole and electron density in a light emitting layer of the organic light emitting device. For device stability, the materials also need to improve an interface with electrodes including metals or metal oxides.

In addition to the properties described above, materials used in an organic light emitting device for a solution process additionally need to have properties as follows.

First, a storable homogeneous solution needs to be formed. Commercialized materials for a deposition process have favorable crystallinity, and are not favorably dissolved in a solution, or crystals are readily caught when forming a solution. Therefore, a concentration gradient of the solution may vary depending on the time of storage, or possibility of forming a defective device is high.

Second, layers going through a solution process need to have solvent and material tolerance for other layers. For this, materials capable of forming a self-crosslinked polymer on a substrate through heat treatment or ultraviolet

(UV) irradiation after coating a solution by introducing a curing group such as VNPB (N4,N4'-di(naphthalen-1-yl)-N4,N4'-bis(4-vinylphenyl)biphenyl-4,4'-diamine) or forming a polymer having sufficient tolerance for a next process are preferred, and materials capable of having solvent tolerance by itself such as HATCN (hexaazatriphenylene hexacarbonitrile) are also preferred.

Accordingly, development of organic materials fulfilling such requirements has been required in the art.

[Disclosure]

[Technical Problem]

The present specification is directed to providing a polymer, and an organic light emitting device formed using the same.

[Technical Solution]

One embodiment of the present specification provides a polymer represented by the following Chemical Formula 1.

[Chemical Formula 1] $E1\text{-}[A]_a\text{-}[B]_b\text{-}[C]_c\text{-}E2$

In Chemical Formula 1,

A is represented by the following Chemical Formula 2,
B is represented by the following Chemical Formula 3,
C is a substituted or unsubstituted arylene group; or a substituted or unsubstituted divalent heterocyclic group,
E1 and E2 are the same as or different from each other, and each independently hydrogen; deuterium; a substituted or unsubstituted alkyl group; a substituted or unsubstituted silyl group; a substituted or unsubstituted aryl group; a substituted or unsubstituted arylamine group; a substituted or unsubstituted siloxane group; a crosslinking group; or a combination thereof,
a, b and c are each a mole fraction,
a is a real number of $0<a\leq1$,
b is a real number of $0\leq b<1$,
c is a real number of $0\leq c<1$, and
a+b+c is 1,

[Chemical Formula 2]

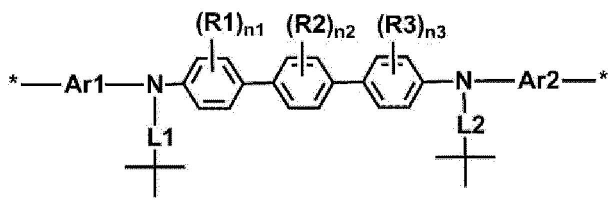

in Chemical Formula 2,
Ar1, Ar2, L1 and L2 are the same as or different from each other, and each independently a substituted or unsubstituted arylene group,
R1 to R3 are the same as or different from each other, and each independently hydrogen; deuterium; a halogen group; a substituted or unsubstituted alkyl group; a substituted or unsubstituted silyl group; a substituted or unsubstituted aryl group; a substituted or unsubstituted heterocyclic group; a substituted or unsubstituted arylamine group; or a substituted or unsubstituted siloxane group,
n1 to n3 are each an integer of 1 to 4,
when n1 to n3 are each 2 or greater, substituents in each parenthesis are the same as or different from each other, and
* is a point of attachment in the polymer,

[Chemical Formula 3]

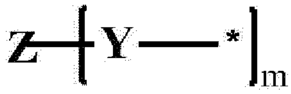

in Chemical Formula 3,
m is an integer of 3 or 4,
when m is 3, Z is CRa; SiRa; N; or a trivalent substituted or unsubstituted aryl group,
when m is 4, Z is C; Si; or a tetravalent substituted or unsubstituted aryl group,
Ra is hydrogen; a substituted or unsubstituted alkyl group; or a substituted or unsubstituted aryl group,
Y is a direct bond; a substituted or unsubstituted alkylene group; or a substituted or unsubstituted arylene group,
when Y is a direct bond; or a substituted or unsubstituted alkylene group, Z is a trivalent or tetravalent substituted or unsubstituted aryl group, and
* is a point of attachment in the polymer.

Another embodiment of the present specification provides a polymer including a unit represented by the following Chemical Formula 2 and an end group represented by the following Chemical Formula 5.

[Chemical Formula 2]

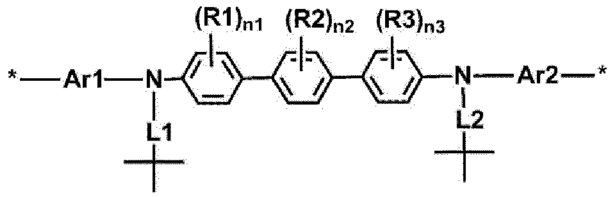

[Chemical Formula 5] * - [E]

In Chemical Formulae 2 and 5,

Ar1, Ar2, L1 and L2 are the same as or different from each other, and each independently a substituted or unsubstituted arylene group,
R1 to R3 are the same as or different from each other, and each independently hydrogen; deuterium; a halogen group; a substituted or unsubstituted alkyl group; a substituted or unsubstituted silyl group; a substituted or unsubstituted aryl group; a substituted or unsubstituted heterocyclic group; a substituted or unsubstituted arylamine group; or a substituted or unsubstituted siloxane group,
n1 to n3 are each an integer of 1 to 4,
when n1 to n3 are each 2 or greater, substituents in each parenthesis are the same as or different from each other,
E is hydrogen; deuterium; a substituted or unsubstituted alkyl group; a substituted or unsubstituted silyl group; a substituted or unsubstituted aryl group; a substituted or unsubstituted arylamine group; a substituted or unsubstituted siloxane group; a crosslinking group; or a combination thereof, and
* is a point of attachment in the polymer.

Another embodiment of the present specification provides an organic light emitting device including a first electrode; a second electrode; and one or more organic material layers provided between the first electrode and the second electrode, wherein one or more layers of the organic material layers include the polymer.

[Advantageous Effects]

In a polymer according to one embodiment of the present specification, Chemical Formula 2 includes a tert-butyl group. Accordingly, the prepared polymer has enhanced uniformity and solubility.
In addition, the polymer according to one embodiment of the present specification is used in a hole transfer layer of an organic light emitting device to enhance performance and lifetime properties of the device.

[Description of Drawings]

FIG. 1 and FIG. 2 are diagrams illustrating organic light emitting devices according to some embodiments of the present specification.
FIG. 3 is a diagram showing GPC measurement results for polymers prepared in some embodiments of the present specification.
FIG. 4 is a diagram showing a result of film retention rate test for a thin film formed using Coating Composition 1 prepared in Experimental Example 2-1.
FIG. 5 is a diagram showing a result of film retention rate test for a thin film formed using Coating Composition 2 prepared in Comparative Example 2-1.

1: Substrate
2: Anode
3: Light Emitting Layer
4: Cathode
5: Hole Injection Layer
6: Hole Transfer Layer
7: Electron Injection and Transfer Layer

[Mode for Disclosure]

Hereinafter, the present specification will be described in more detail.

One embodiment of the present specification provides a polymer represented by the following Chemical Formula 1.

[Chemical Formula 1] $E1\text{-}[A]_a\text{-}[B]_b\text{-}[C]_c\text{-}E2$

In Chemical Formula 1,

A is represented by the following Chemical Formula 2,
B is represented by the following Chemical Formula 3,
C is a substituted or unsubstituted arylene group; or a substituted or unsubstituted divalent heterocyclic group,
E1 and E2 are the same as or different from each other, and each independently hydrogen; deuterium; a substituted or unsubstituted alkyl group; a substituted or unsubstituted silyl group; a substituted or unsubstituted aryl group; a substituted or unsubstituted arylamine group; a substituted or unsubstituted siloxane group; a crosslinking group; or a combination thereof,
a, b and c are each a mole fraction,
a is a real number of $0<a\leq1$,
b is a real number of $0\leq b<1$,
c is a real number of $0\leq c<1$, and
a+b+c is 1,

[Chemical Formula 2]

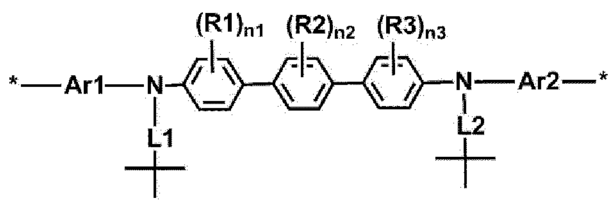

in Chemical Formula 2,
Ar1, Ar2, L1 and L2 are the same as or different from each other, and each independently a substituted or unsubstituted arylene group,
R1 to R3 are the same as or different from each other, and each independently hydrogen; deuterium; a halogen group; a substituted or unsubstituted alkyl group; a substituted or unsubstituted silyl group; a substituted or unsubstituted aryl group; a substituted or unsubstituted heterocyclic group; a substituted or unsubstituted arylamine group; or a substituted or unsubstituted siloxane group,

n1 to n3 are each an integer of 1 to 4,

when n1 to n3 are each 2 or greater, substituents in each parenthesis are the same as or different from each other, and

* is a point of attachment in the polymer,

[Chemical Formula 3]

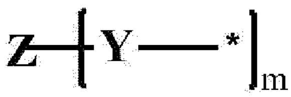

in Chemical Formula 3,

m is an integer of 3 or 4,

when m is 3, Z is CRa; SiRa; N; or a trivalent substituted or unsubstituted aryl group,

when m is 4, Z is C; Si; or a tetravalent substituted or unsubstituted aryl group,

Ra is hydrogen; a substituted or unsubstituted alkyl group; or a substituted or unsubstituted aryl group,

Y is a direct bond; a substituted or unsubstituted alkylene group; or a substituted or unsubstituted arylene group,

when Y is a direct bond; or a substituted or unsubstituted alkylene group, Z is a trivalent or tetravalent substituted or unsubstituted aryl group, and

* is a point of attachment in the polymer.

In the polymer, Chemical Formula 2 includes a tert-butyl group. Accordingly, the prepared polymer has enhanced uniformity and solubility. In addition, the polymer is effective in controlling its molecular weight through adjusting the size of the alkyl group.

In the present specification, the polymer having enhanced uniformity means the prepared polymer having narrow molecular weight distribution (PDI).

In the present specification, the molecular weight distribution (PDI) is calculated through the following Equation (1) .

Equation (1): PDI=weight average molecular weight (Mw)/number average molecular weight (Mn)

A polymer having wide molecular weight distribution means that molecules with various molecular weights are distributed, which means that reproducibly synthesizing the polymer is difficult. Accordingly, polymer uniformity decreases as molecular weight distribution is wider.

In one embodiment of the present specification, the molecular weight of the polymer is measured using a gel permeation chromatography (GPC) method.

In one embodiment of the present specification, the polymer has molecular weight distribution (PDI) of 1 to 10. Preferably, the polymer has molecular weight distribution of 1 to 5. More preferably, the polymer has molecular weight distribution of 1 to 3.

In the present specification, a description of a certain member being placed "on" another member includes not only a case of the certain member being in contact with the another member but a case of still another member being present between the two members.

In the present specification, a description of a certain part "including" certain constituents means capable of further including other constituents, and does not exclude other constituents unless particularly stated on the contrary.

Examples of substituents in the present specification are described below, however, the substituents are not limited thereto.

The term "substitution" means a hydrogen atom bonding to a carbon atom of a compound being changed to another substituent. The position of substitution is not limited as long as it is a position at which the hydrogen atom is substituted, that is, a position at which a substituent is capable of substituting, and when substituted with two or more, the two or more substituents may be the same as or different from each other.

In the present specification, the term "substituted or unsubstituted" means being substituted with one, two or more substituents selected from the group consisting of deuterium; a halogen group; an alkyl group; a cycloalkyl group; an alkoxy group; an aryloxy group; an amine group; an aryl group; and a heterocyclic group, or being substituted with

a substituent linking two or more substituents among the substituents illustrated above, or having no substituents. For example, the "substituent linking two or more substituents" may include a biphenyl group. In other words, a biphenyl group may be an aryl group, or interpreted as a substituent linking two phenyl groups.

Examples of the substituents are described below, however, the substituents are not limited thereto.

In the present specification, examples of the halogen group may include fluorine (F), chlorine (Cl), bromine (Br) or iodine (I).

In the present specification, the alkyl group may be linear or branched, and although not particularly limited thereto, the number of carbon atoms is preferably from 1 to 60. According to one embodiment, the number of carbon atoms of the alkyl group is from 1 to 30. Specific examples of the alkyl group may include a methyl group, an ethyl group, a propyl group, an isopropyl group, a butyl group, an isobutyl group, a tert-butyl group, a pentyl group, a hexyl group, a heptyl group, an octyl group and the like, but are not limited thereto.

In the present specification, the number of carbon atoms of the cycloalkyl group is not particularly limited, but is preferably from 3 to 60. According to one embodiment, the number of carbon atoms of the cycloalkyl group is from 3 to 30. Specific examples of the cycloalkyl group may include a cyclopropyl group, a cyclobutyl group, a cyclopentyl group, a cyclohexyl group, a cycloheptyl group, a cyclooctyl group and the like, but are not limited thereto.

In the present specification, the alkoxy group may be linear, branched or cyclic. The number of carbon atoms of the alkoxy group is not particularly limited, but is preferably from 1 to 30. Specific examples of the alkoxy group may include methoxy, ethoxy, n-propoxy, isopropoxy, n-butoxy, isobutoxy, tert-butoxy, sec-butoxy, n-pentyloxy, neopentyloxy, isopentyloxy, n-hexyloxy, 3,3-dimethylbutyloxy, 2-ethylbutyloxy, n-octyloxy, n-nonyloxy, n-decyloxy and the like, but are not limited thereto.

In the present specification, a fluoroalkoxy group means an alkoxy group substituted with F.

In the present specification, the amine group may be selected from the group consisting of $-NH_2$; an alkylamine group; an arylalkylamine group; an arylamine group; an arylheteroarylamine group; an alkylheteroarylamine group and a heteroarylamine group, but is not limited thereto. The number of carbon atoms of the amine group is not particularly limited, but is preferably from 1 to 60.

In the present specification, the number of carbon atoms of the aryl group is not particularly limited, but is preferably from 6 to 60. According to one embodiment, the number of carbon atoms of the aryl group is from 6 to 30. In one embodiment of the present specification, the aryl group may be a monocyclic aryl group or a polycyclic aryl group. Examples of the monocyclic aryl group may include a phenyl group, a biphenyl group, a terphenyl group and the like, but are not limited thereto. Examples of the polycyclic aryl group may include a naphthyl group, an anthracenyl group, a phenanthrenyl group, a pyrenyl group, a perylenyl group, a triphenyl group, a chrysenyl group, a fluorenyl group and the like, but are not limited thereto.

In the present specification, examples of the arylamine group may include a substituted or unsubstituted monoarylamine group, a substituted or unsubstituted diarylamine group, or a substituted or unsubstituted triarylamine group. The aryl group in the arylamine group may be a monocyclic aryl group or a polycyclic aryl group. The arylamine group including two or more aryl groups may include monocyclic aryl groups, polycyclic aryl groups, or both monocyclic aryl groups and polycyclic aryl groups. For example, the aryl group in the arylamine group may be selected from among the examples of the aryl group described above.

In the present specification, the arylene group means an aryl group having two bonding sites, that is, a divalent group. The descriptions on the aryl group provided above may be applied thereto except that the arylene group is a divalent group.

In the present specification, the heterocyclic group is a group including one or more atoms that are not carbon, that is, heteroatoms, and specifically, the heteroatom may include one or more atoms selected from the group consisting of O, N, Se, S and the like. The number of carbon atoms of the heterocyclic group is not particularly limited, but is preferably from 2 to 30. In one embodiment of the present specification, the heterocyclic group may be monocyclic or polycyclic. Examples of the heterocyclic group may include a thiophene group, a furan group, a pyrrole group, an imidazole group, a thiazole group, an oxazole group, an oxadiazole group, a pyridine group, a bipyridine group, a pyrimidine group, a triazine group, a triazole group, an acridine group, a pyridazine group, a pyrazine group, a quinoline group, a quinazoline group, a quinoxaline group, a phthalazine group, a pyridopyrimidine group, a pyridopyrazine group, a pyrazinopyrazine group, an isoquinoline group, an indole group, a carbazole group, a benzoxazole group, a benzimidazole group, a benzothiazole group, a benzocarbazole group, a benzothiophene group, a dibenzothiophene group, a benzofuran group, a phenanthridine group, a phenanthroline group, an isoxazole group, a thiadiazole group, a phenothiazine group, a dibenzofuran group and the like, but are not limited thereto.

In the present specification, the divalent heterocyclic group may be polycyclic or monocyclic, and means having two bonding sites in the heterocyclic group. For example, examples of the divalent heterocyclic group may include a divalent thiophene group; a divalent carbazole group; a divalent dibenzofuran group; a divalent dibenzothiophene group and the like, but are not limited thereto.

In the present specification, the aryloxy group is a group represented by $-OR_{200}$, and $R_{200}$ is an aryl group.

The aryl group in the aryloxy group is the same as the examples of the aryl group described above. Specific examples of the aryloxy group may include a phenoxy group, a benzyloxy group, a p-methylbenzyloxy group, a p-tolyloxy group, an m-tolyloxy group, a 3,5-dimethyl-phenoxy group, a 2,4,6-trimethylphenoxy group, a p-tert-butylphenoxy group, a 3-biphenyloxy group, a 4-biphenyloxy group, a 1-naphthyloxy group, a 2-naphthyloxy group, a 4-methyl-1-naphthyloxy group, a 5-methyl-2-naphthyloxy group, a 1-anthryloxy group, a 2-anthryloxy group, a 9-anthryloxy group, a 1-phenanthryloxy group, a 3-phenanthryloxy group, a 9-phenanthryloxy group and the like, but are not limited thereto.

In the present specification, the silyl group is a group represented by $-SiR_{201}R_{202}R_{203}$, and $R_{201}$, $R_{202}$ and $R_{203}$ are the same as or different from each other and each independently hydrogen; deuterium; a substituted or unsubstituted alkyl group; or a substituted or unsubstituted aryl group. Examples of the silyl group may include a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group and the like, but are not limited thereto.

In the present specification, the siloxane group is a group represented by $-Si(R_{204})_2OSi(R_{205})_3$ or $-OSi(R_{204})_3Si(R_{205})_3$, and $R_{204}$ and $R_{205}$ are the same as or different from each other and each independently hydrogen; deuterium; a substituted or unsubstituted alkyl group; or a substituted or unsubstituted aryl group.

In the present specification, the crosslinking group may mean a reactive substituent crosslinking compounds by being exposed to heat, light and/or radiation. The crosslinking may be generated by linking radicals generated while carbon-carbon multiple bonds or cyclic structures are decomposed by heat treatment, light irradiation or radiation irradiation.

In one embodiment of the present specification, the crosslinking group is any one of the following structures.

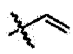
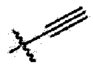
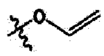
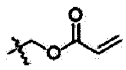
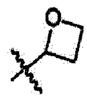
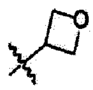
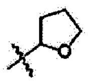
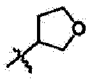
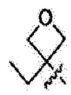
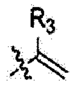
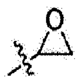
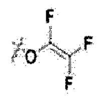
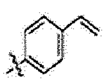
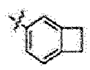
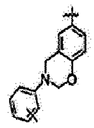
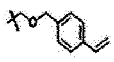
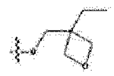

In the structures, 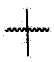 means a site bonding to other substituents or bonding sites.

In the present specification, an "adjacent" group may mean a substituent substituting an atom directly linked to an atom substituted by the corresponding substituent, a substituent sterically most closely positioned to the corresponding substituent, or another substituent substituting an atom substituted by the corresponding substituent. For example, two substituents substituting ortho positions in a benzene ring, and two substituents substituting the same carbon in an aliphatic ring may be interpreted as groups "adjacent" to each other.

In the present specification, in the ring formed by adjacent groups bonding to each other, the "ring" means a substituted or unsubstituted hydrocarbon ring; or a substituted or unsubstituted heteroring.

In the present specification, the "mole fraction" means a ratio of the number of moles of a given component with respect to the total number of moles of all components.

In one embodiment of the present specification, L1 and L2 are the same as or different from each other, and each independently a substituted or unsubstituted arylene group having 6 to 30 carbon atoms.

In one embodiment of the present specification, L1 and L2 are the same as or different from each other, and each independently an arylene group having 6 to 30 carbon atoms.

In one embodiment of the present specification, L1 and L2 are the same as or different from each other, and each independently a substituted or unsubstituted phenylene group; a substituted or unsubstituted biphenylene group; or a substituted or unsubstituted terphenylene group.

In one embodiment of the present specification, L1 and L2 are the same as or different from each other, and each independently a phenylene group; a biphenylene group; or a terphenylene group.

In one embodiment of the present specification, Chemical Formula 2 is represented by the following Chemical Formula 2-1.

[Chemical Formula 2-1]

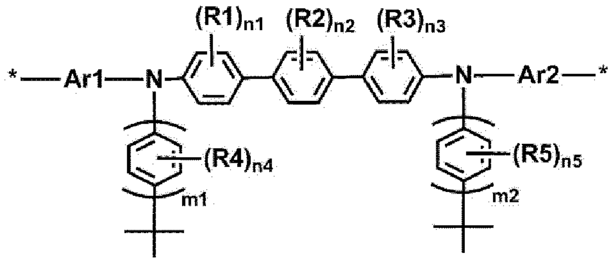

In Chemical Formula 2-1,

R1 to R3, Ar1, Ar2 and n1 to n3 have the same definitions as in Chemical Formula 2,
R4 and R5 are the same as or different from each other, and each independently hydrogen; deuterium; a halogen group; or a substituted or unsubstituted alkyl group,
m1 and m2 are each an integer of 1 to 3,
when m1 and m2 are each 2 or greater, structures in each parenthesis are the same as or different from each other,
n4 and n5 are each an integer of 1 to 4,
when n4 and n5 are each 2 or greater, substituents in each parenthesis are the same as or different from each other, and
* is a point of attachment in the polymer.

In one embodiment of the present specification, m1 and m2 are each 2.
In one embodiment of the present specification, Chemical Formula 2 is represented by the following Chemical Formula 2-2.

[Chemical Formula 2-2]

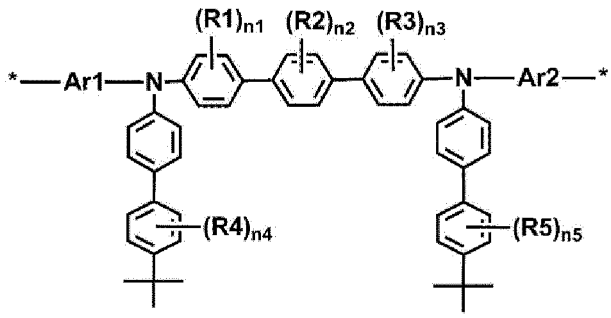

In Chemical Formula 2-2,

R1 to R3, Ar1, Ar2 and n1 to n3 have the same definitions as in Chemical Formula 2,
R4 and R5 are the same as or different from each other, and each independently hydrogen; deuterium; a halogen group; or a substituted or unsubstituted alkyl group,
n4 and n5 are each an integer of 1 to 4,
when n4 and n5 are each 2 or greater, substituents in each parenthesis are the same as or different from each other, and
* is a point of attachment in the polymer.

In one embodiment of the present specification, Ar1 and Ar2 are the same as or different from each other, and each independently a substituted or unsubstituted arylene group having 6 to 30 carbon atoms.
In one embodiment of the present specification, Ar1 and Ar2 are the same as or different from each other, and each independently an arylene group having 6 to 30 carbon atoms.
In one embodiment of the present specification, Ar1 and Ar2 are the same as or different from each other, and each independently a substituted or unsubstituted phenylene group; a substituted or unsubstituted biphenylene group; or a substituted or unsubstituted terphenylene group.

In one embodiment of the present specification, Ar1 and Ar2 are the same as or different from each other, and each independently a phenylene group; a biphenylene group; or a terphenylene group.

In one embodiment of the present specification, Chemical Formula 2 is represented by the following Chemical Formula 2-3.

[Chemical Formula 2-3]

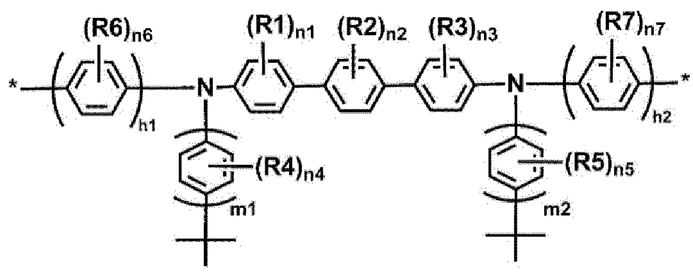

In Chemical Formula 2-3,

R1 to R3, Ar1, Ar2 and n1 to n3 have the same definitions as in Chemical Formula 2,
R4 to R7 are the same as or different from each other, and each independently hydrogen; deuterium; a halogen group; or a substituted or unsubstituted alkyl group,
n4 to n7 are each an integer of 1 to 4,
when n4 to n7 are each 2 or greater, substituents in each parenthesis are the same as or different from each other,
m1, m2, h1 and h2 are each an integer of 1 to 3,
when m1, m2, h1 and h2 are each 2 or greater, structures in each parenthesis are the same as or different from each other, and
* is a point of attachment in the polymer.

In one embodiment of the present specification, R1 to R3 are hydrogen; or a substituted or unsubstituted alkyl group.

In one embodiment of the present specification, R1 to R3 are hydrogen; or a substituted or unsubstituted alkyl group having 1 to 10 carbon atoms.

In one embodiment of the present specification, R1 to R3 are hydrogen; or an alkyl group.

In one embodiment of the present specification, R1 to R3 are hydrogen; a methyl group; or a hexyl group.

In one embodiment of the present specification, R1 and R3 are hydrogen; or a methyl group.

In one embodiment of the present specification, R2 is a hexyl group.

In one embodiment of the present specification, R4 and R5 are each hydrogen.

In one embodiment of the present specification, h1 and h2 are each 2.

In one embodiment of the present specification, R6 and R7 are each hydrogen.

In one embodiment of the present specification, L1 and L2 are the same as or different from each other, and each independently a substituted or unsubstituted biphenyl group.

In one embodiment of the present specification, L1 and L2 are the same as or different from each other, and each independently a biphenylene group.

In one embodiment of the present specification, Ar1 and Ar2 are the same as or different from each other, and each independently a substituted or unsubstituted biphenyl group.

In one embodiment of the present specification, Ar1 and Ar2 are the same as or different from each other, and each independently a biphenylene group.

In one embodiment of the present specification, Chemical Formula 2 is the following structure.

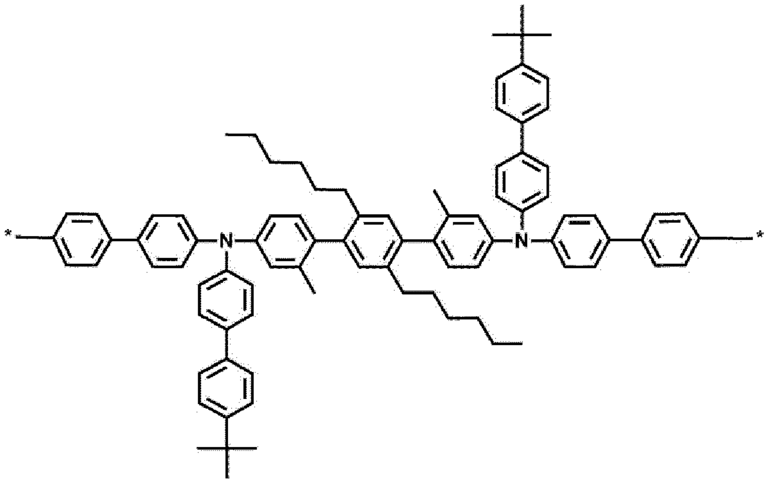

In the structure, * is a point of attachment in the polymer.

In one embodiment of the present specification, a is, as a mole fraction, a real number of $0<a\leq1$. In other words, the polymer requisitely includes A.

In one embodiment of the present specification, b is, as a mole fraction, a real number of $0\leq b<1$. In other words, the polymer optionally includes B.

In one embodiment of the present specification, B is a unit having 3 or 4 points of attachment.

In one embodiment of the present specification, Y is a direct bond; or a substituted or unsubstituted arylene group.

In one embodiment of the present specification, Y is a direct bond; or a substituted or unsubstituted phenylene group.

In one embodiment of the present specification, Chemical Formula 3 is represented by any one of the following Chemical Formulae 3-1 to 3-4.

[Chemical Formula 3-1]

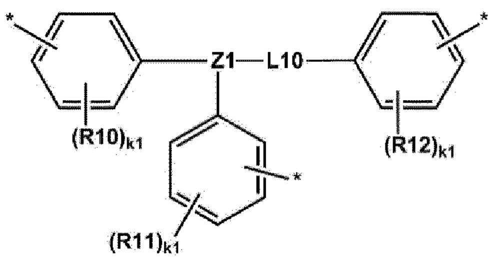

[Chemical Formula 3-2]

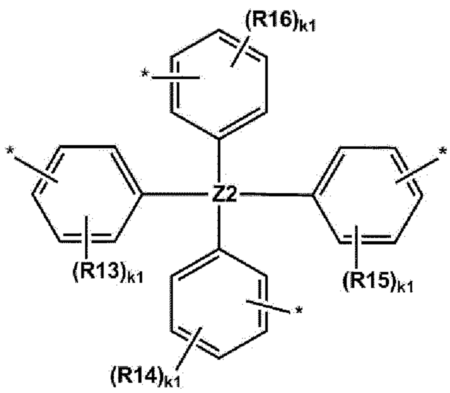

[Chemical Formula 3-3]

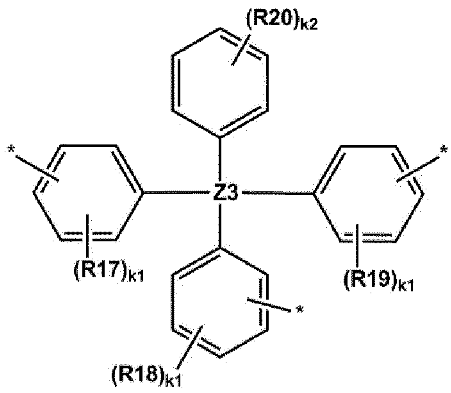

[Chemical Formula 3-4]

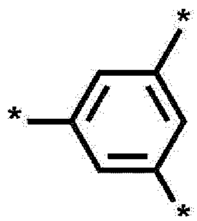

In Chemical Formulae 3-1 to 3-4,

Z1 is CRa; SiRa; N; or a trivalent substituted or unsubstituted aryl group,
Z2 and Z3 are the same as or different from each other, and each independently C; Si; or a tetravalent substituted or unsubstituted aryl group,
L10 is a direct bond; or a substituted or unsubstituted arylene group,
Ra is hydrogen; a substituted or unsubstituted alkyl group; or a substituted or unsubstituted aryl group,
R10 to R20 are the same as or different from each other, and each independently hydrogen; deuterium; a halogen group; a cyano group; an alkoxy group; an aryloxy group; a fluoroalkoxy group; a siloxane group; a substituted or unsubstituted amine group; a substituted or unsubstituted alkyl group; a substituted or unsubstituted aryl group; a substituted or unsubstituted heterocyclic group; or a crosslinking group, and adjacent groups may bond to each other to form a ring,
k1 is an integer of 1 to 4,
k2 is an integer of 1 to 5,
when k1 is 2 or greater, substituents in the parentheses are the same as or different from each other,
when k2 is 2 or greater, substituents in the parentheses are the same as or different from each other, and
* is a point of attachment in the polymer.

In one embodiment of the present specification, Chemical Formula 3 is represented by Chemical Formula 3-1.
In one embodiment of the present specification, when Z1 is CRa or SiRa and Ra is a substituted or unsubstituted aryl group, L10 is a substituted or unsubstituted arylene group.
In one embodiment of the present specification, Z1 is CH; SiH; N; or a substituted or unsubstituted trivalent aryl group.
In one embodiment of the present specification, Z1 is CH; SiH; N; or a substituted or unsubstituted trivalent phenyl group.
In one embodiment of the present specification, Z1 is N; or a trivalent phenyl group.
In one embodiment of the present specification, L10 is a direct bond; or a substituted or unsubstituted arylene group having 6 to 30 carbon atoms.
In one embodiment of the present specification, L10 is a direct bond; or an arylene group having 6 to 30 carbon atoms.
In one embodiment of the present specification, L10 is a direct bond; or a phenylene group.
In one embodiment of the present specification, L10 is a direct bond.
In one embodiment of the present specification, Chemical Formula 3 is represented by Chemical Formula 3-2.
In one embodiment of the present specification, Z2 is C; or Si.

In one embodiment of the present specification, B is represented by Chemical Formula 3-3.

In one embodiment of the present specification, Z3 is C; or Si.

In one embodiment of the present specification, Chemical Formula 3 is represented by Chemical Formula 3-4.

In one embodiment of the present specification, Chemical Formula 3 is represented by any one of the following structures.

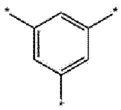
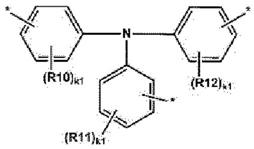
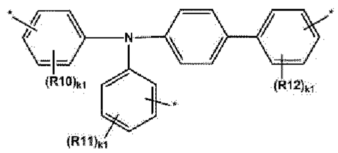

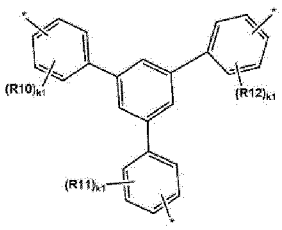
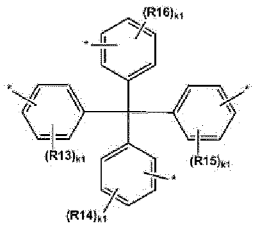
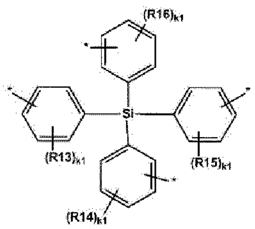

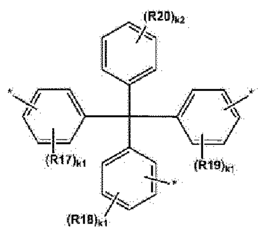
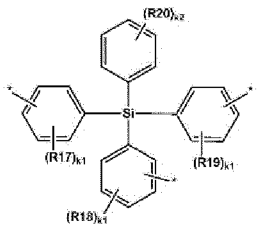

In the structures,

R10 to R20 are the same as or different from each other, and each independently hydrogen; deuterium; a halogen group; a cyano group; an alkoxy group; an aryloxy group; a fluoroalkoxy group; a siloxane group; a substituted or unsubstituted amine group; a substituted or unsubstituted alkyl group; a substituted or unsubstituted aryl group; a substituted or unsubstituted heterocyclic group; or a crosslinking group, and adjacent groups may bond to each other to form a ring,
k1 is an integer of 1 to 4,
k2 is an integer of 1 to 5,
when k1 is 2 or greater, substituents in the parentheses are the same as or different from each other,
when k2 is 2 or greater, substituents in the parentheses are the same as or different from each other, and
* is a point of attachment in the polymer.

In one embodiment of the present specification, R10 to R20 are each hydrogen.

Specifically, Chemical Formula 3 is represented by any one of the following structures.

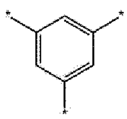
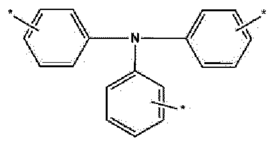
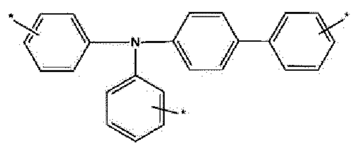

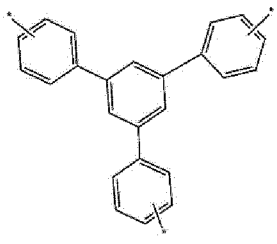
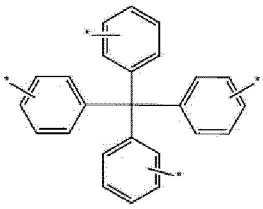
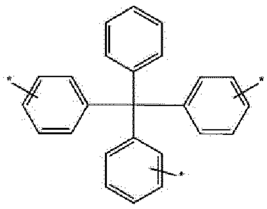

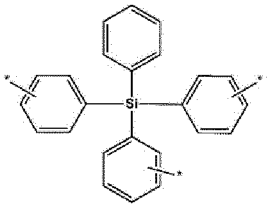
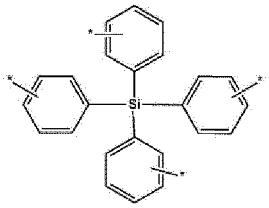

In the structures, * is a point of attachment in the polymer.

More specifically, Chemical Formula 3 is represented by any one of the following structures.

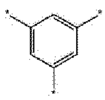
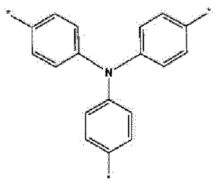
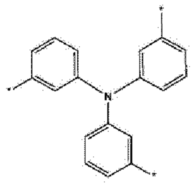
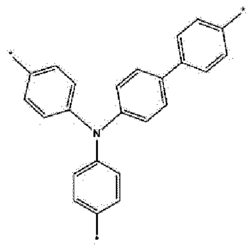

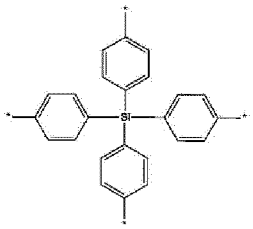
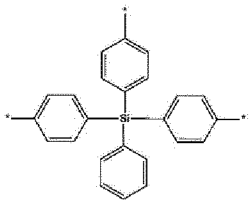
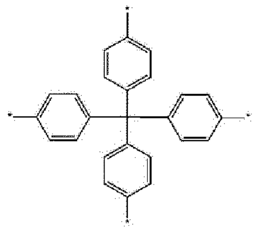

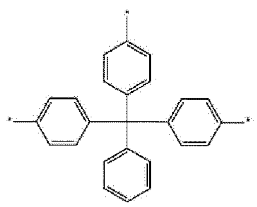
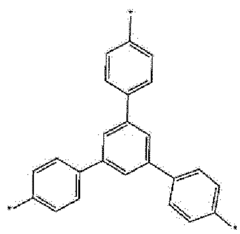
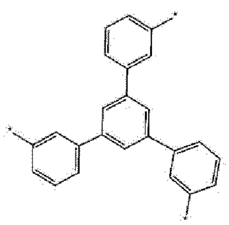

In the structures, * is a point of attachment in the polymer.

More specifically, Chemical Formula 3 is represented by any one of the following structures.

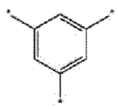
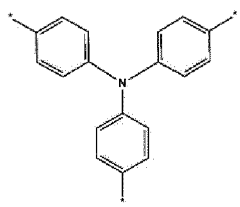
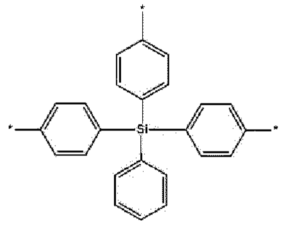

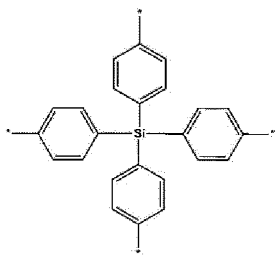
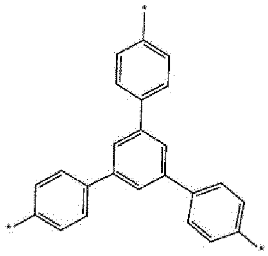
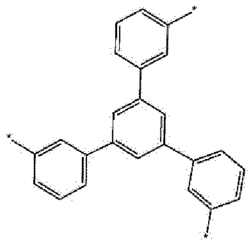

In the structures, * is a point of attachment in the polymer.

In one embodiment of the present specification, c is, as a mole fraction, a real number of $0 \leq c < 1$. In other words, the polymer optionally includes C.

In one embodiment of the present specification, C is a unit having two points of attachment.

In one embodiment of the present specification, C is a substituted or unsubstituted arylene group; or a substituted or unsubstituted divalent heterocyclic group,

In one embodiment of the present specification, C is an arylene group unsubstituted or substituted with deuterium or a crosslinking group; or a divalent heterocyclic group unsubstituted or substituted with deuterium or a crosslinking group.

In one embodiment of the present specification, C is any one of the following structures.

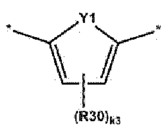
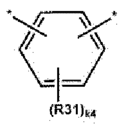
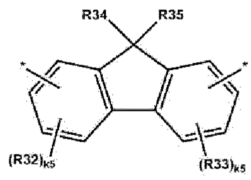
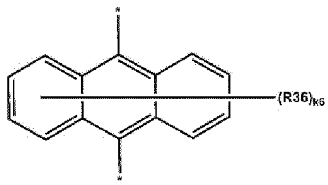
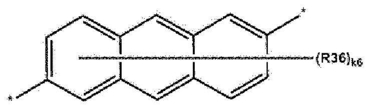
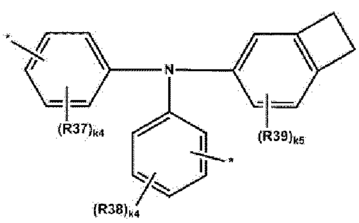
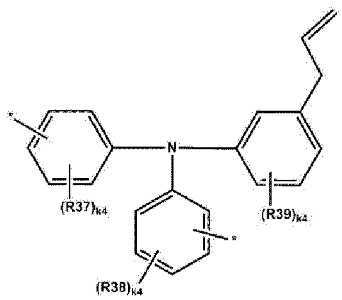

In the structures,

Y1 is S, O or NR100,
R30 to R39 and R100 are the same as or different from each other, and each independently hydrogen; deuterium; a substituted or unsubstituted alkyl group; a substituted or unsubstituted aryl group; or a crosslinking group,
k3 is an integer of 1 or 2,
k4 is an integer of 1 to 4,
k5 is an integer of 1 to 3,
k6 is an integer of 1 to 8,
when k3 to k6 are each 2 or greater, substituents in each parenthesis are the same as or different from each other, and
* is a point of attachment in the polymer.

Specifically, C is any one of the following structures.

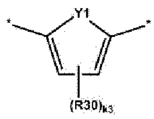 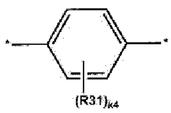 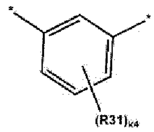

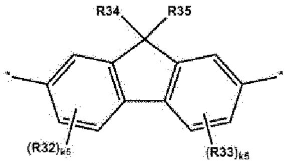 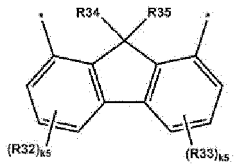

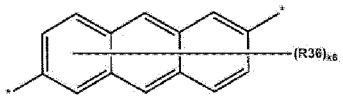 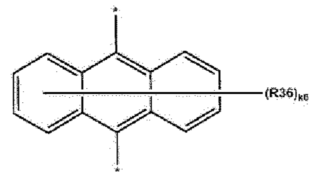

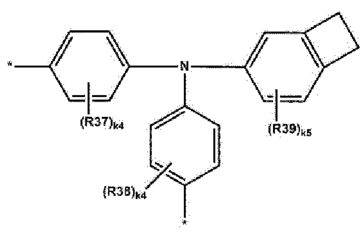 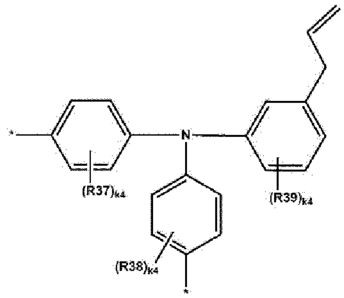

In the structures,

- Y1 is S, O or NR100,
- R30 to R39 and R100 are the same as or different from each other, and each independently hydrogen; deuterium; a substituted or unsubstituted alkyl group; a substituted or unsubstituted aryl group; or a crosslinking group,
- k3 is an integer of 1 or 2,
- k4 is an integer of 1 to 4,
- k5 is an integer of 1 to 3,
- k6 is an integer of 1 to 8,
- when k3 to k6 are each 2 or greater, substituents in each parenthesis are the same as or different from each other, and
- * is a point of attachment in the polymer.

More specifically, C is any one of the following structures.

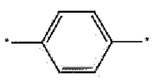 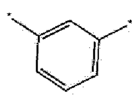 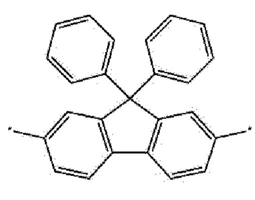 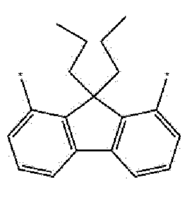

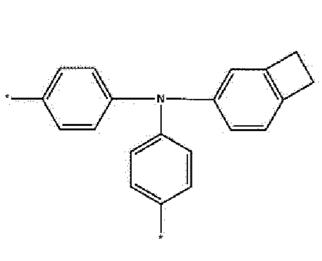 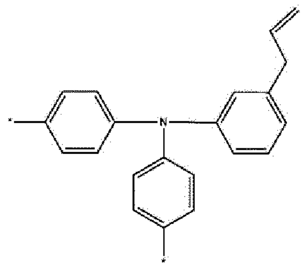

In the structures, * is a point of attachment in the polymer.
In one embodiment of the present specification, E1 and E2 are an end-capping unit of the polymer.
In one embodiment of the present specification, E1 and E2 are a unit having only one point of attachment.
In one embodiment of the present specification, E1 and E2 are the same as or different from each other, and each independently a substituted or unsubstituted alkyl group; a substituted or unsubstituted aryl group; a crosslinking group; or a combination thereof.
In one embodiment of the present specification, E1 and E2 are the same as or different from each other, and each independently a substituted or unsubstituted alkyl group having 1 to 30 carbon atoms; a substituted or unsubstituted aryl group having 6 to 30 carbon atoms; a crosslinking group; or a combination thereof.
In one embodiment of the present specification, E1 and E2 are the same as or different from each other, and each independently a substituted or unsubstituted alkyl group having 1 to 10 carbon atoms; a substituted or unsubstituted phenyl group; a substituted or unsubstituted biphenyl group; a crosslinking group; or a combination thereof.
In one embodiment of the present specification, E1 and E2 are each any one of the following structures.

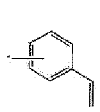 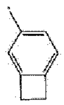 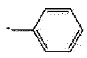 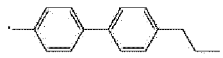 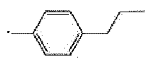

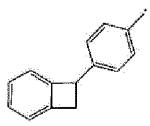 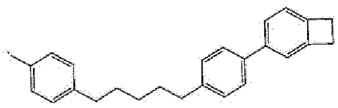 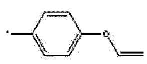

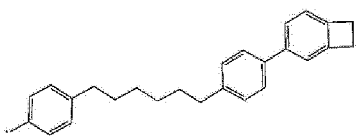 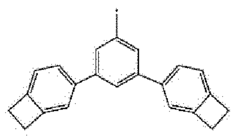 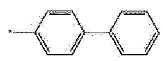

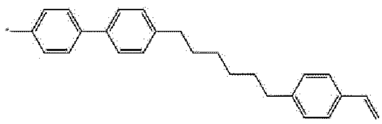 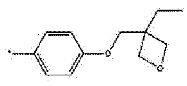 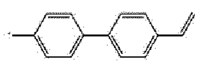

In the structures, * is a point of attachment in the polymer.
More specifically, E1 and E2 are each any one of the following structures.

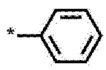 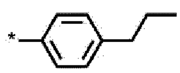 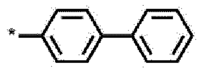

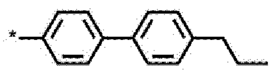 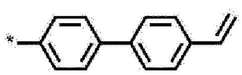

In the structures, * is a point of attachment in the polymer.
In one embodiment of the present specification, a, b and c are determined by an equivalent ratio of monomers

used when preparing the polymer.

In one embodiment of the present specification, a is a real number of 0.4 or greater.

In one embodiment of the present specification, a is a real number of 0.4 to 1.

In one embodiment of the present specification, a is a real number of 0.5 to 1.

In one embodiment of the present specification, a is a real number of 0.5 to 0.9.

In one embodiment of the present specification, a is a real number of 0.5 to 0.8.

In one embodiment of the present specification, b is a real number of 0 or greater.

In one embodiment of the present specification, b is a real number of 0 to 0.5.

In one embodiment of the present specification, b is a real number of 0.1 to 0.4.

In one embodiment of the present specification, b is a real number of 0.1 to 0.3.

In one embodiment of the present specification, b is a real number of 0.1 to 0.3.

In one embodiment of the present specification, c is a real number of 0 to 0.2.

In one embodiment of the present specification, c is a real number of 0 to 0.1.

In one embodiment of the present specification, c is 0.

In one embodiment of the present specification, a is a real number of 0.4 to 1, b is a real number of 0 to 0.4, and c is a real number of 0 to 0.2.

In one embodiment of the present specification, a is a real number of 0.4 to 0.9, b is a real number of 0.1 to 0.4, and c is a real number of 0 to 0.2.

In one embodiment of the present specification, (A+B):(E1+E2) have a molar ratio of 40:60 to 98:2.

One embodiment of the present specification provides a polymer including a unit represented by the following Chemical Formula 2 and an end group represented by Chemical Formula 5.

[Chemical Formula 2]

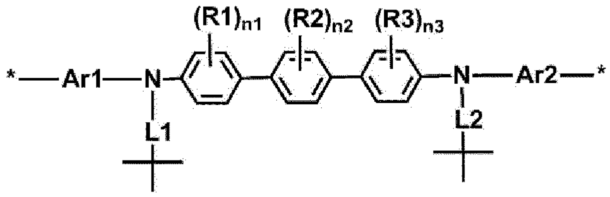

[Chemical Formula 5] *-[E]

In Chemical Formulae 2 and 5,

Ar1, Ar2, L1 and L2 are the same as or different from each other, and each independently a substituted or unsubstituted arylene group,

R1 to R3 are the same as or different from each other, and each independently hydrogen; deuterium; a halogen group; a substituted or unsubstituted alkyl group; a substituted or unsubstituted silyl group; a substituted or unsubstituted aryl group; a substituted or unsubstituted heterocyclic group; a substituted or unsubstituted arylamine group; or a substituted or unsubstituted siloxane group,

n1 to n3 are each an integer of 1 to 4,

when n1 to n3 are each 2 or greater, substituents in each parenthesis are the same as or different from each other,

E is hydrogen; deuterium; a substituted or unsubstituted alkyl group; a substituted or unsubstituted silyl group; a substituted or unsubstituted aryl group; a substituted or unsubstituted arylamine group; a substituted or unsubstituted siloxane group; a crosslinking group; or a combination thereof, and

* is a point of attachment in the polymer.

In one embodiment of the present specification, the polymer represented by Chemical Formula 1 may be expressed as the polymer including the unit represented by Chemical Formula 2 and the end group represented by Chemical Formula 5. Specifically, when b and c of Chemical Formula 1 are 0, the polymer represented by Chemical Formula 1 may be expressed as the polymer including the unit represented by Chemical Formula 2 and the end group represented by Chemical Formula 5.

In one embodiment of the present specification, the polymer including the unit represented by Chemical Formula 2 and the end group represented by Chemical Formula 5 further includes a unit represented by the following Chemical Formula 3.

[Chemical Formula 3]

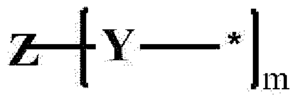

In Chemical Formula 3,

m is an integer of 3 or 4,
when m is 3, Z is CRa; SiRa; N; or a trivalent substituted or unsubstituted aryl group,
when m is 4, Z is C; Si; or a tetravalent substituted or unsubstituted aryl group,
Ra is hydrogen; a substituted or unsubstituted alkyl group; or a substituted or unsubstituted aryl group,
Y is a direct bond; a substituted or unsubstituted alkylene group; or a substituted or unsubstituted arylene group,
when Y is a direct bond; or a substituted or unsubstituted alkylene group, Z is a trivalent or tetravalent substituted or unsubstituted aryl group, and
* is a point of attachment in the polymer.

In other words, one embodiment of the present specification provides a polymer including the unit represented by Chemical Formula 2, the unit represented by Chemical Formula 3 and the end group represented by Chemical Formula 5.
Herein, the polymer represented by Chemical Formula 1 may be expressed as the polymer including the unit represented by Chemical Formula 2, the unit represented by Chemical Formula 3 and the end group represented by Chemical Formula 5.
Specifically, when b is a real number of greater than 0 and less than 1 and c is 0 in Chemical Formula 1, the polymer represented by Chemical Formula 1 may be expressed as the polymer including the unit represented by Chemical Formula 2, the unit represented by Chemical Formula 3 and the end group represented by Chemical Formula 5.
In one embodiment of the present specification, the polymer including the unit represented by Chemical Formula 2 and the end group represented by Chemical Formula 5 further includes a unit represented by the following Chemical Formula 4.

[Chemical Formula 4] *-[C]-*

In Chemical Formula 4,

C is a substituted or unsubstituted arylene group; or a substituted or unsubstituted divalent heterocyclic group, and
* is a point of attachment in the polymer.

In other words, one embodiment of the present specification provides a polymer including the unit represented by Chemical Formula 2, the unit represented by Chemical Formula 4 and the end group represented by Chemical Formula 5.
Herein, the polymer represented by Chemical Formula 1 may be expressed as the polymer including the unit represented by Chemical Formula 2, the unit represented by Chemical Formula 4 and the end group represented by Chemical Formula 5.
Specifically, when b is 0 and c is a real number of greater than 0 and less than 1 in Chemical Formula 1, the polymer represented by Chemical Formula 1 may be expressed as the polymer including the unit represented by Chemical Formula 2, the unit represented by Chemical Formula 4 and the end group represented by Chemical Formula 5.
In addition, one embodiment of the present specification provides a polymer including the unit represented by Chemical Formula 2, the unit represented by Chemical Formula 3, the unit represented by Chemical Formula 4 and the end group represented by Chemical Formula 5.
Herein, the polymer represented by Chemical Formula 1 may be expressed as the polymer including the unit represented by Chemical Formula 2, the unit represented by Chemical Formula 3, the unit represented by Chemical Formula 4 and the end group represented by Chemical Formula 5.
Specifically, when b and c are each a real number of greater than 0 and less than 1 in Chemical Formula 1, the polymer represented by Chemical Formula 1 may be expressed as the polymer including the unit represented by Chemical Formula 2, the unit represented by Chemical Formula 3, the unit represented by Chemical Formula 4 and the end group represented by Chemical Formula 5.
In one embodiment of the present specification, the descriptions on Chemical Formula 2 provided above in

Chemical Formula 1 are equally applied to descriptions on Chemical Formula 2 of the polymer including the unit represented by Chemical Formula 2 and the end group represented by Chemical Formula 5. For example, in the polymer including the unit represented by Chemical Formula 2 and the end group represented by Chemical Formula 5, Chemical Formula 2 may be represented by Chemical Formula 2-1.

In one embodiment of the present specification, when the polymer including the unit represented by Chemical Formula 2 and the end group represented by Chemical Formula 5 further includes the unit represented by Chemical Formula 3, the descriptions on Chemical Formula 3 provided above in Chemical Formula 1 are equally applied to descriptions on Chemical Formula 3. For example, in the polymer including the unit represented by Chemical Formula 2, the unit represented by Chemical Formula 3 and the end group represented by Chemical Formula 5, Chemical Formula 3 may be represented by any one of Chemical Formulae 3-1 to 3-4.

The descriptions on Chemical Formulae 2 and 3 are equally applied in the polymer including the unit represented by Chemical Formula 2, the unit represented by Chemical Formula 3, the unit represented by Chemical Formula 4 and the end group represented by Chemical Formula 5 as well.

In one embodiment of the present specification, when the polymer including the unit represented by Chemical Formula 2 and the end group represented by Chemical Formula 5 further includes Chemical Formula 4, the descriptions on C defined in Chemical Formula 1 are equally applied to descriptions on C of Chemical Formula 4. For example, in the polymer including the unit represented by Chemical Formula 2, the unit represented by Chemical Formula 4 and the end group represented by Chemical Formula 5, C of Chemical Formula 4 is any one of the following structures.

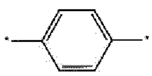
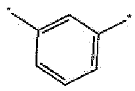
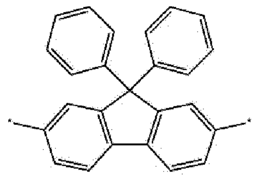
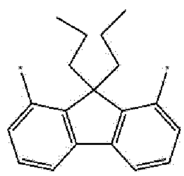
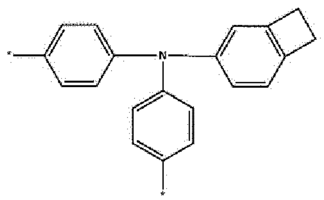
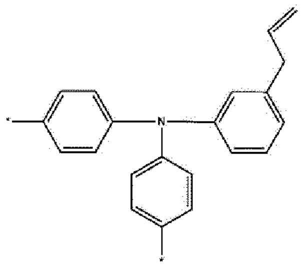

The descriptions on C are equally applied in the polymer including the unit represented by Chemical Formula 2, the unit represented by Chemical Formula 3, the unit represented by Chemical Formula 4 and the end group represented by Chemical Formula 5 as well.

In one embodiment of the present specification, in the polymer including the unit represented by Chemical Formula 2 and the end group represented by Chemical Formula 5, the descriptions on E1 of Chemical Formula 1 are equally applied to descriptions on E of Chemical Formula 5. For example, in the polymer including the unit represented by Chemical Formula 2 and the end group represented by Chemical Formula 5, E is an end-capping unit of the polymer, and may be represented by any one of the following structures.

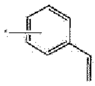
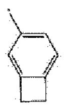
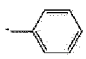
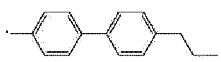
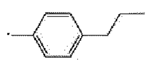
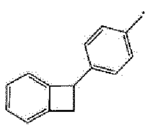
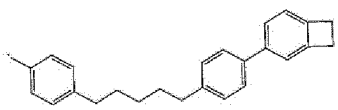
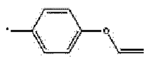

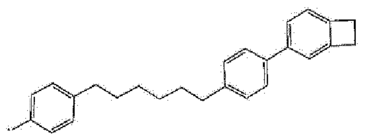
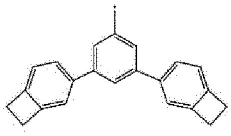
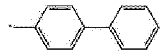

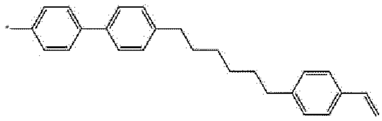
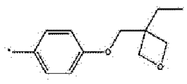
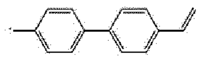

The descriptions on E are equally applied in the polymer including the unit represented by Chemical Formula 2, the unit represented by Chemical Formula 3 and the end group represented by Chemical Formula 5 as well. In addition, the descriptions on E are equally applied in the polymer including the unit represented by Chemical Formula 2, the unit represented by Chemical Formula 3, the unit represented by Chemical Formula 4 and the end group represented by Chemical Formula 5 as well.

In one embodiment of the present specification, the polymer is an alternating polymer, a block polymer or a random polymer.

In one embodiment of the present specification, Chemical Formula 1 does not mean that A1, B1 and C1 are present in this order in the polymer. Specifically, A1, B1 and C1 may be present in various orders in the polymer. For example, the polymer may have an order of E1-A1-B1-C1-E2, E1-A1-C1-B1-E2, E1-B1-A1-C1-E2, E1-B1-C1-A1-E2, E1-C1-A1-B1-E2 or E1-C1-B1-A1-E2.

In addition, Chemical Formula 1 does not have a structure in which A1, B1 and C1 are linked only one by one in the polymer. For example, the units may be linked in various content ranges in the polymer such as E1-A1-B1-A1-C1-E2, E1-A1-C1-B1-C1-E2 or E1-A1-B1-C1-A1-E2. Herein, the content range of A1, B1 and C1 is determined by an equivalent ratio of monomers used when preparing the polymer.

In one embodiment of the present specification, the polymer has a weight average molecular weight (Mw) of 30,000 g/mol to 100,000 g/mol. Specifically, the weight average molecular weight is from 40,000 g/mol to 80,000 g/mol.

When the weight average molecular weight of polymer satisfies the above-mentioned range, the polymer may be used in a device through a solution process, and an effect of maintaining an organic material layer is obtained after used in the device.

In one embodiment of the present specification, the unit represented by Chemical Formula 2, the unit represented by Chemical Formula 3, the unit represented by Chemical Formula 4 and the end group represented by Chemical Formula 5 may be distributed so as to optimize properties of the polymer.

In one embodiment of the present specification, when a mole fraction of the unit represented by Chemical Formula 2 is employed as a1, a mole fraction of the unit represented by Chemical Formula 3 as b1, a mole fraction of the unit represented by Chemical Formula 4 as c1 and a mole fraction of the unit represented by Chemical Formula 5 as e1 in the polymer, a1, b1, c1 and e1 are each a real number, $0<a1<1$, $0\leq b1<1$, $0\leq c1<1$ and $0<e1<1$, and $a1+b1+c1+e1=1$.

In one embodiment of the present specification, a1 is a real number of 0.4 or greater.

In one embodiment of the present specification, a1 is a real number of greater than or equal to 0.4 and less than 1.

In one embodiment of the present specification, a1 is a real number of greater than or equal to 0.5 and less than 1.

In one embodiment of the present specification, a1 is a real number of 0.5 to 0.9.

In one embodiment of the present specification, a1 is a real number of 0.5 to 0.8.

In one embodiment of the present specification, b1 is a real number of 0 or greater.

In one embodiment of the present specification, b1 is a real number of 0 to 0.5.

In one embodiment of the present specification, b1 is a real number of 0.1 to 0.4.

In one embodiment of the present specification, b1 is a real number of 0.1 to 0.3.

In one embodiment of the present specification, c1 is a real number of 0 to 0.2.

In one embodiment of the present specification, c1 is a real number of 0 to 0.1.

In one embodiment of the present specification, c1 is 0.

In one embodiment of the present specification, e1 is a real number of 0.1 to 0.5.

In one embodiment of the present specification, e1 is a real number of 0.1 to 0.4.

In one embodiment of the present specification, e1 is a real number of 0.1 to 0.35.

In one embodiment of the present specification, a1 is a real number of greater than or equal to 0.4 and less than 1, b1 is a real number of 0 to 0.5, c1 is a real number of 0 to 0.2, e1 is a real number of 0.1 to 0.5, and $a1+b1+c1+e1=1$.

In one embodiment of the present specification, a1 is a real number of 0.4 to 0.9, b1 is a real number of 0.1 to 0.4, c1 is a real number of 0 to 0.2, e1 is a real number of 0.1 to 0.5, and $a1+b1+c1+e1=1$.

In one embodiment of the present specification, a1 is a real number of 0.4 to 0.7, b1 is a real number of 0.1 to 0.3, c1 is a real number of 0 to 0.1, e1 is a real number of 0.2 to 0.4, and a1+b1+c1+e1=1.

In one embodiment of the present specification, the polymer is represented by any one of the following structures.

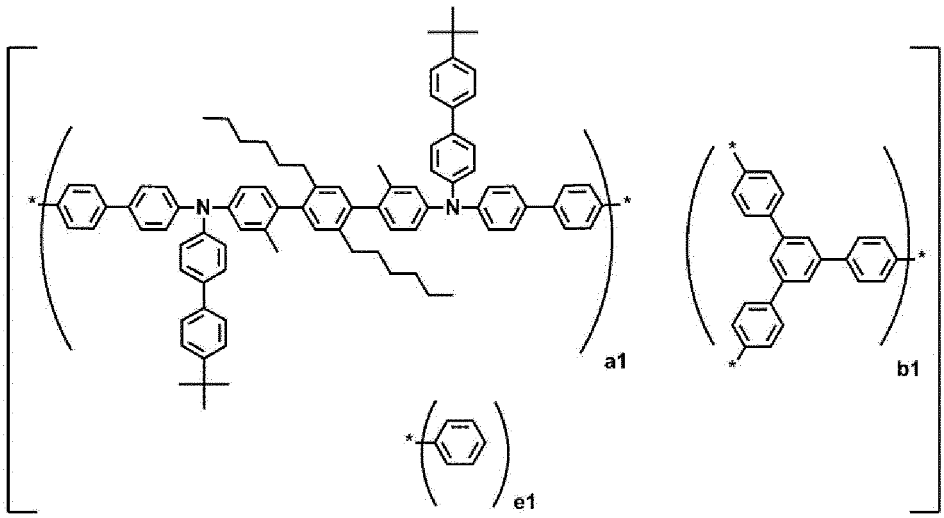

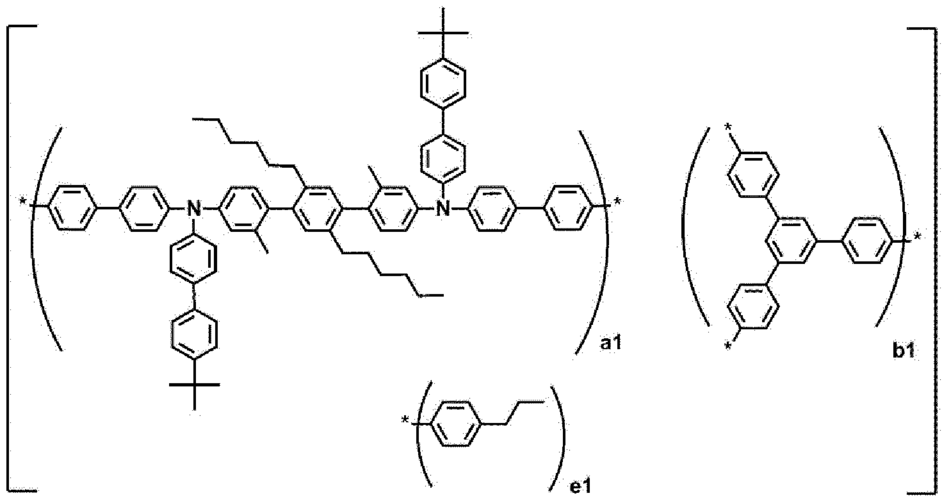

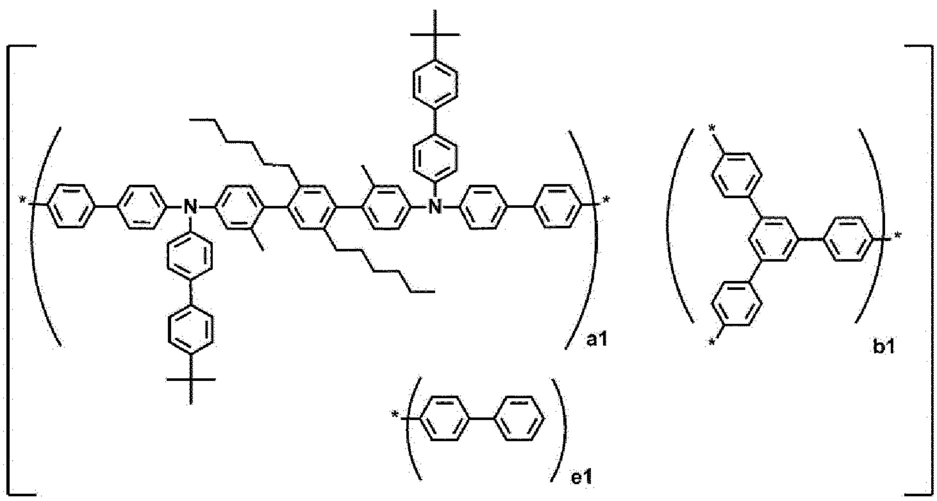

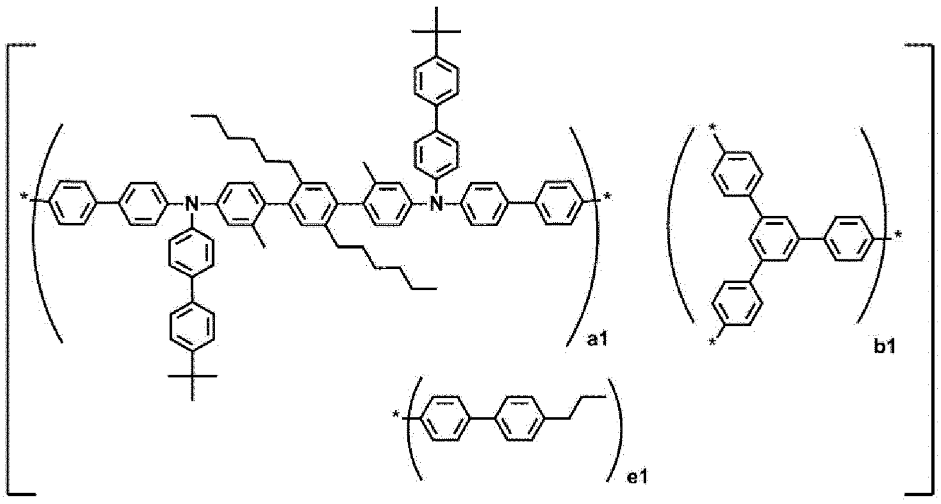

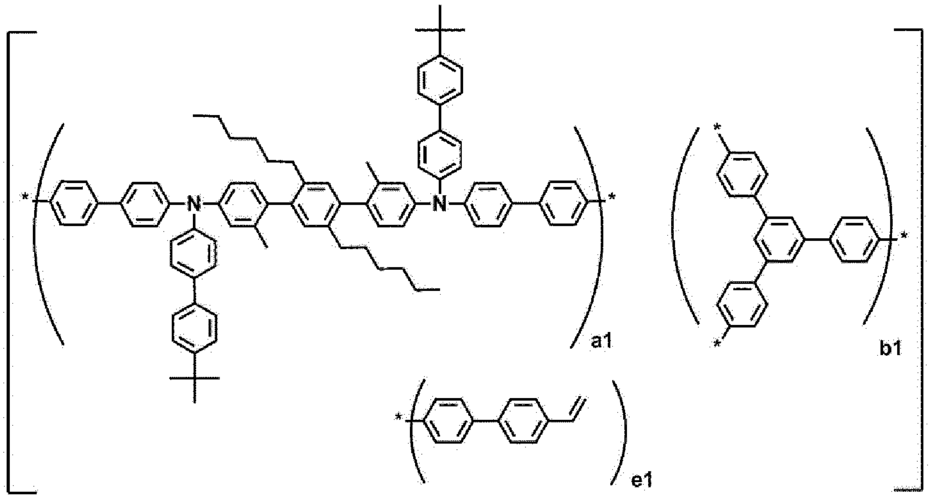

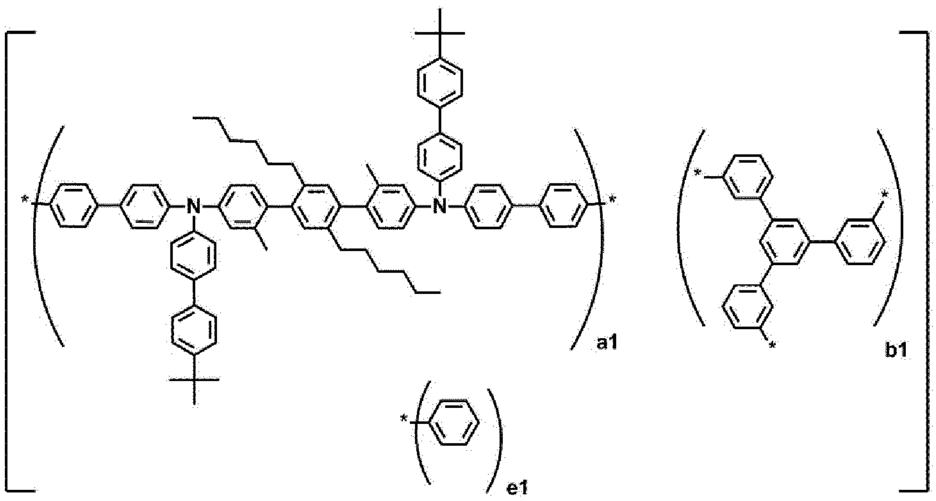

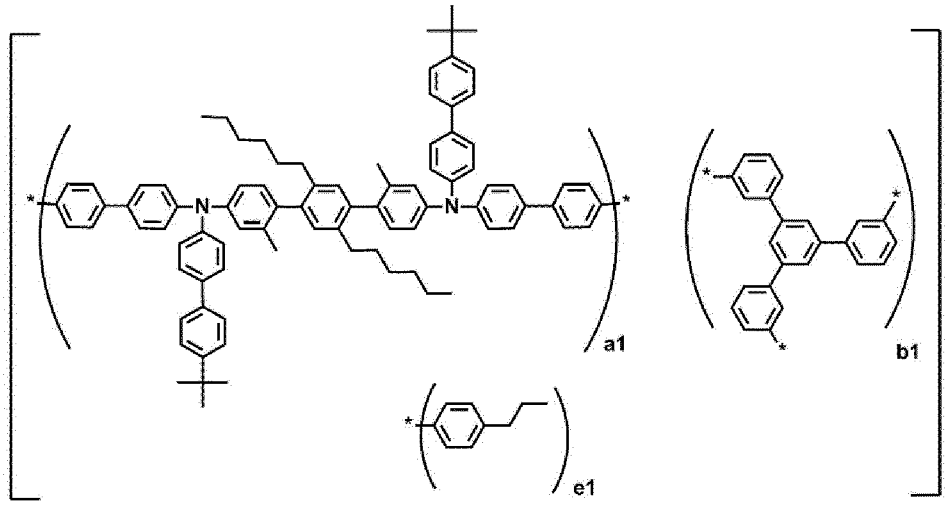

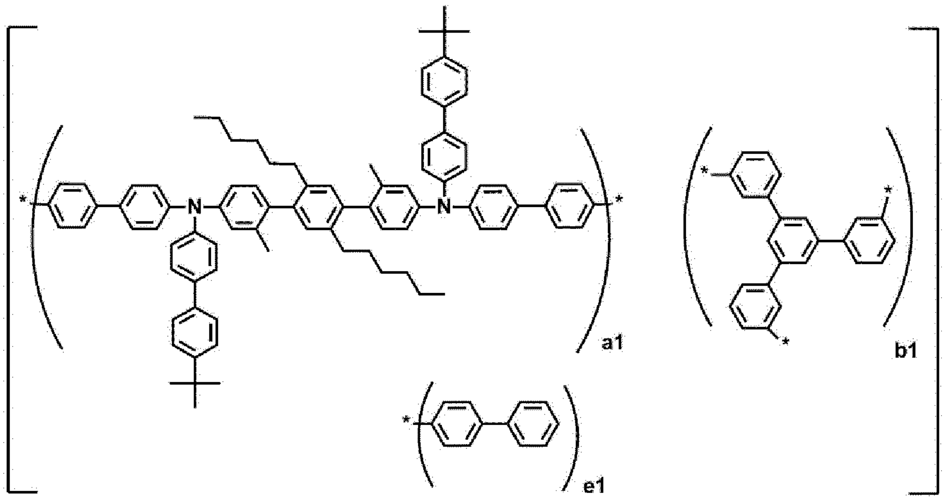

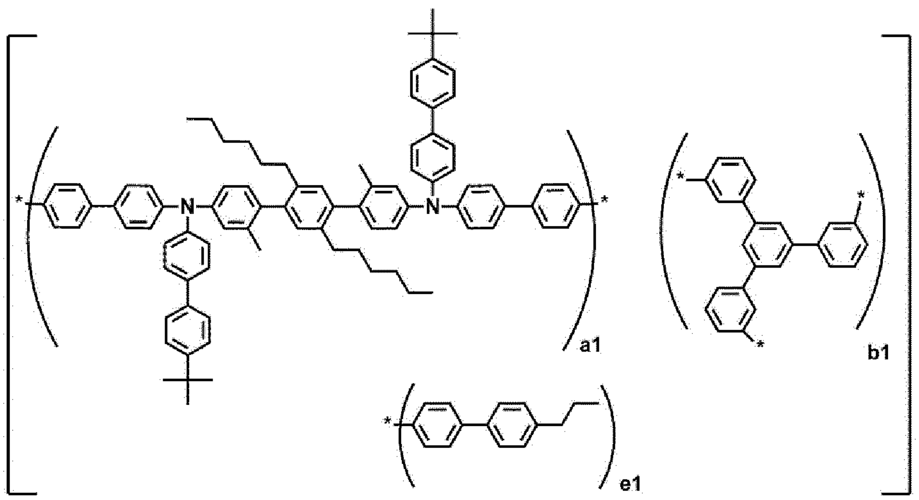

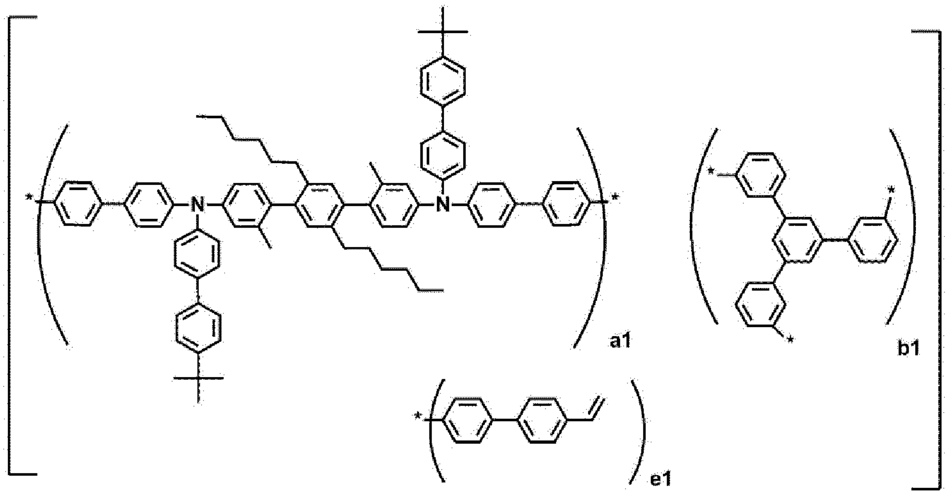

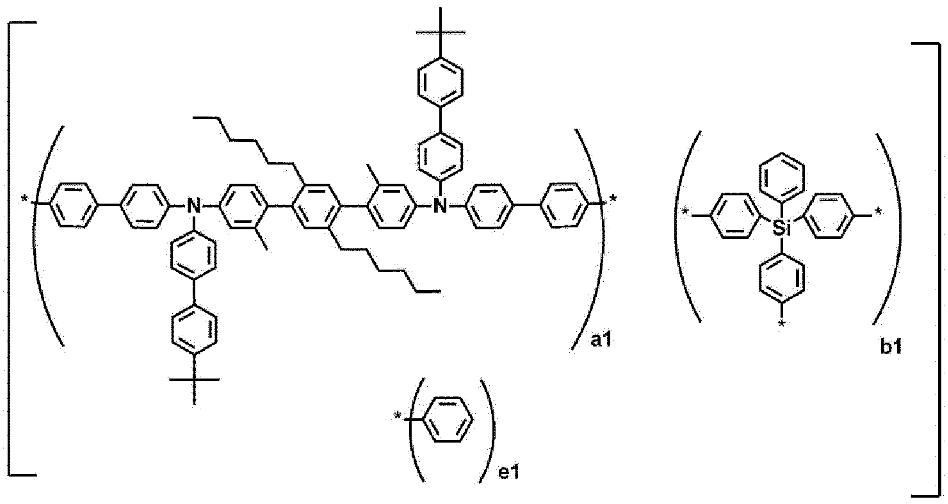

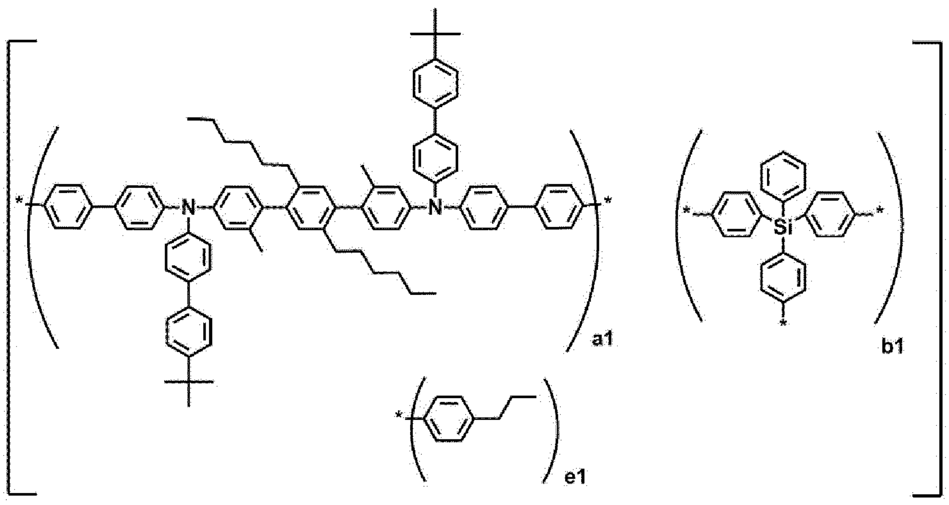

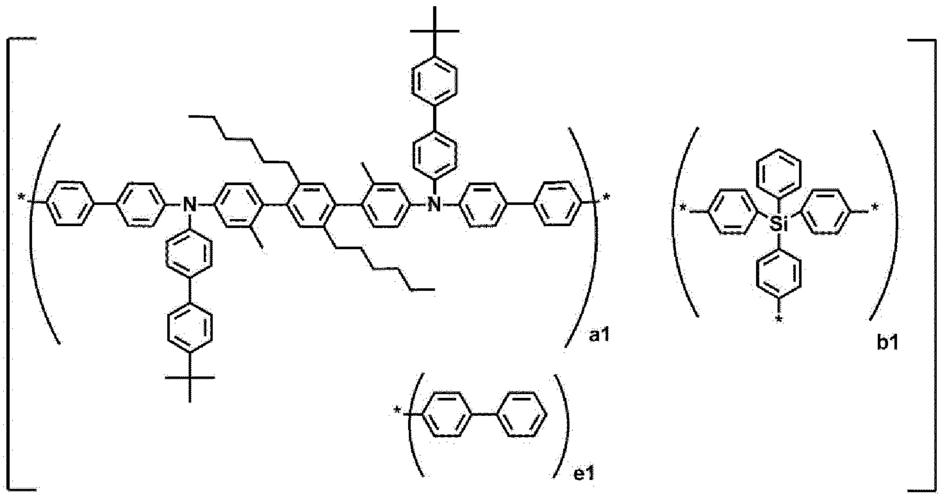

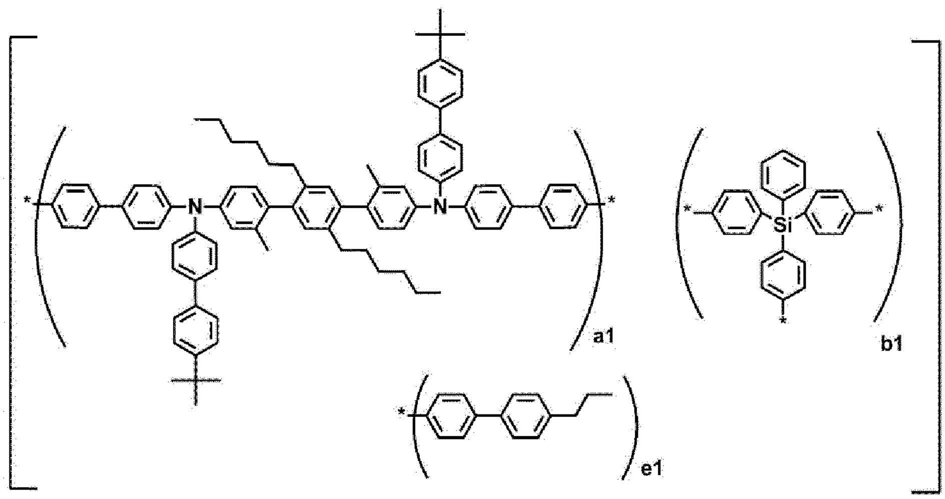

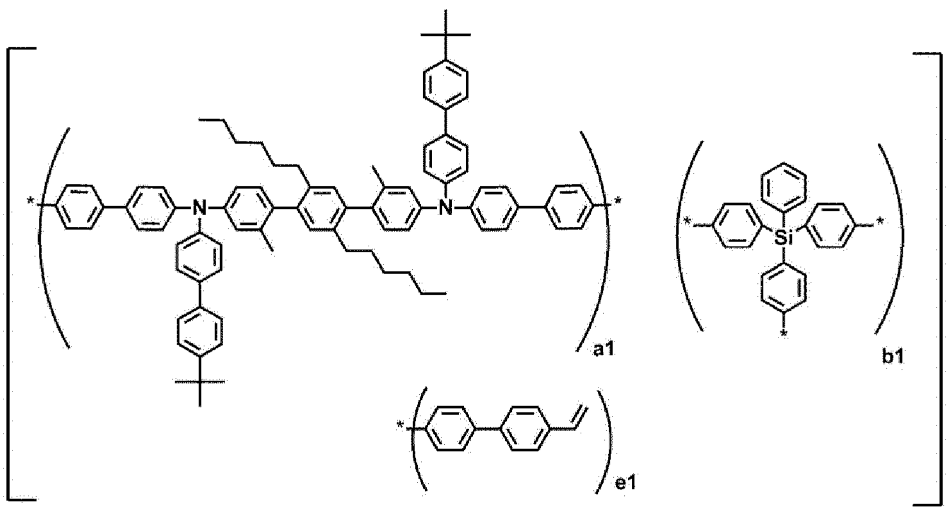

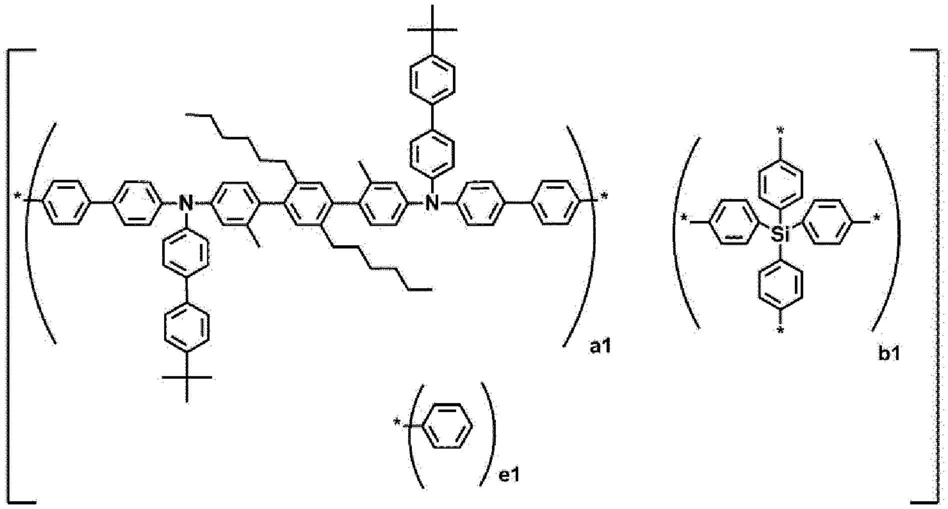

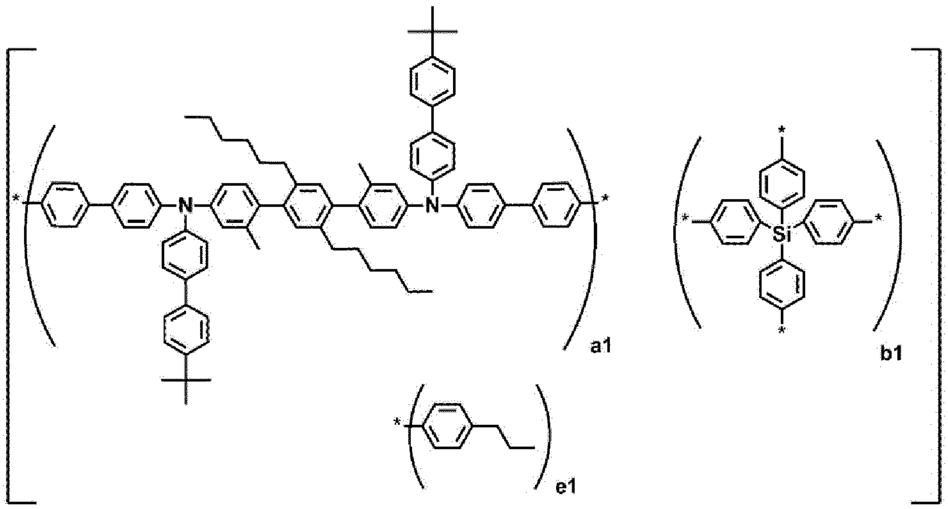

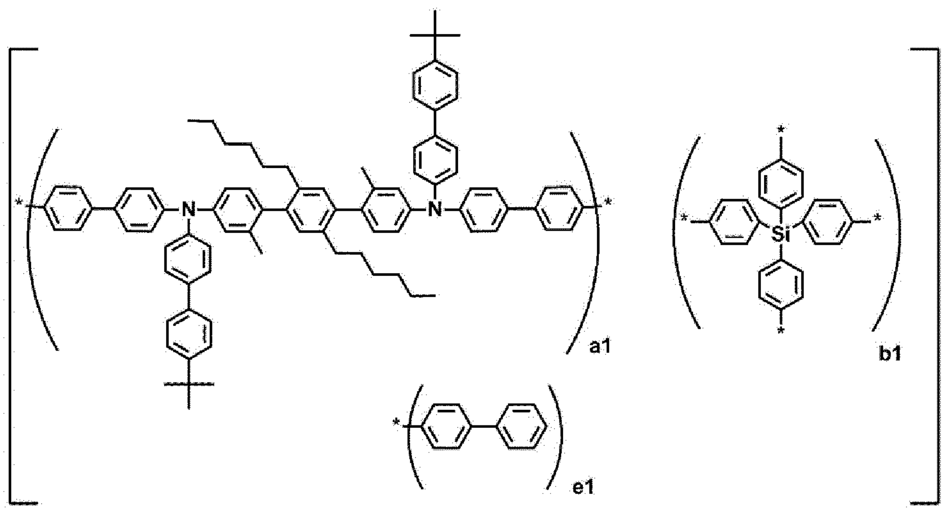

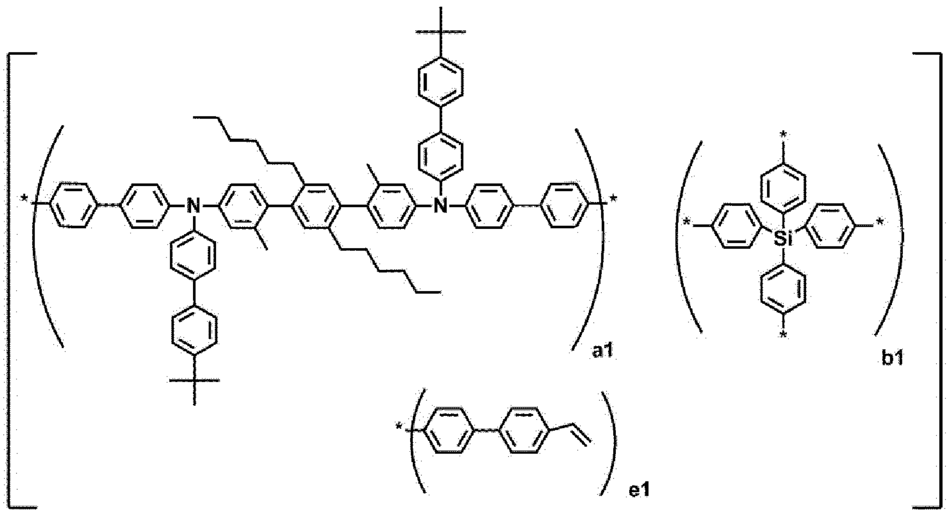

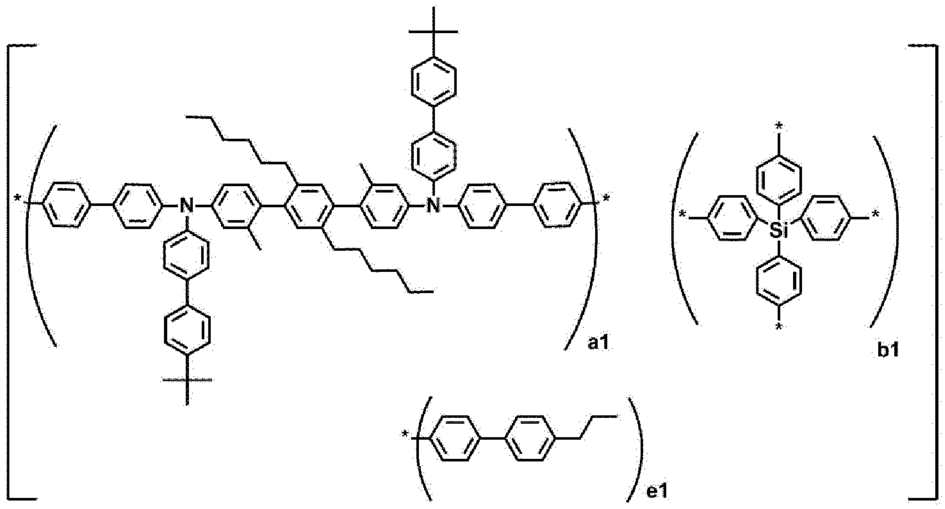

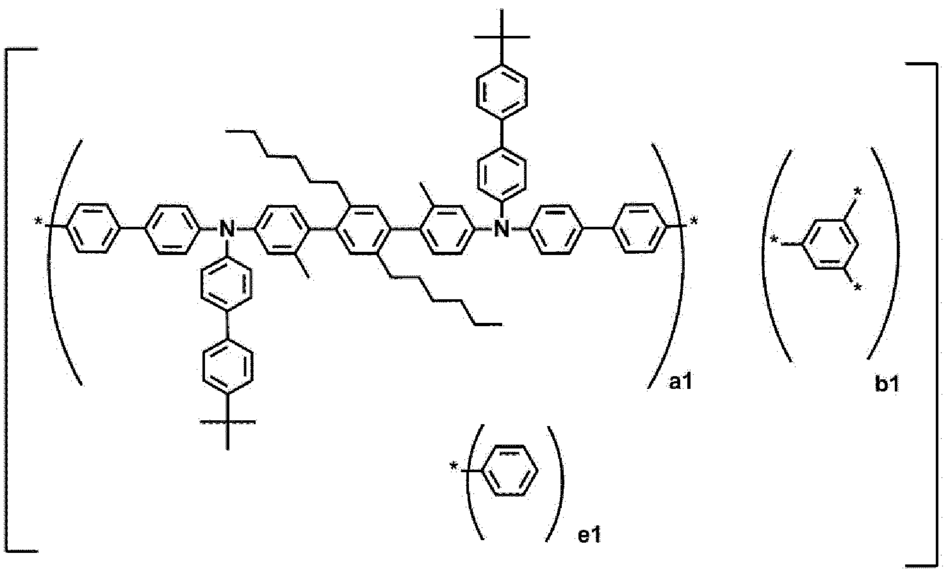

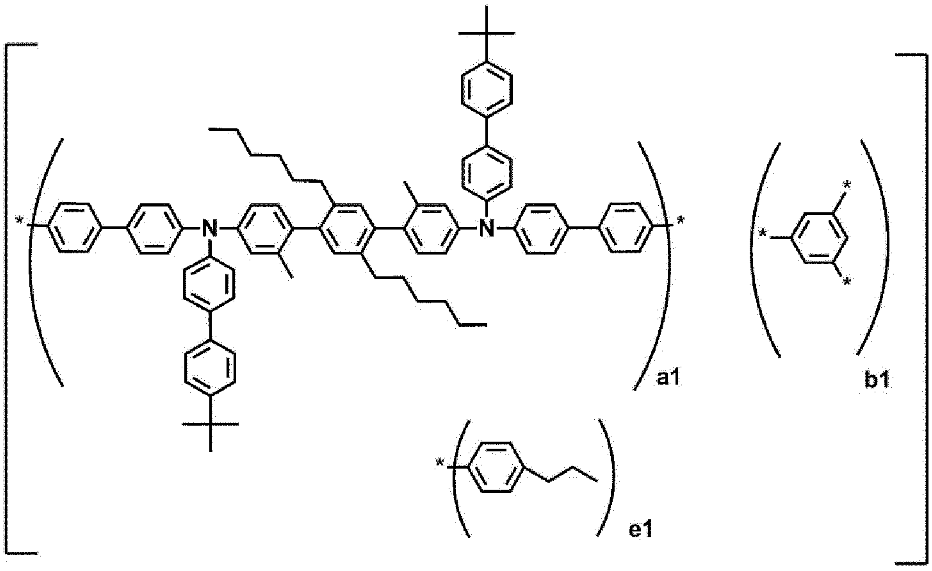

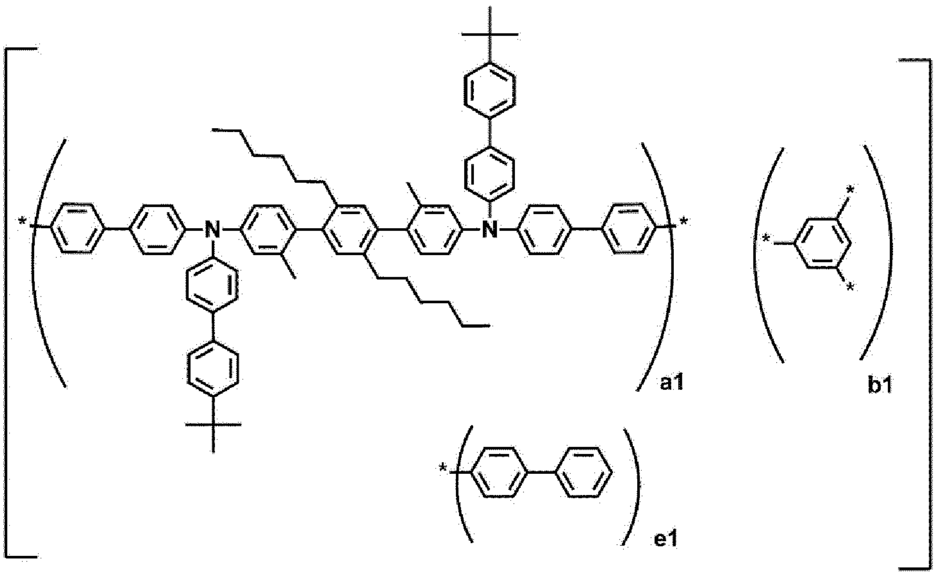

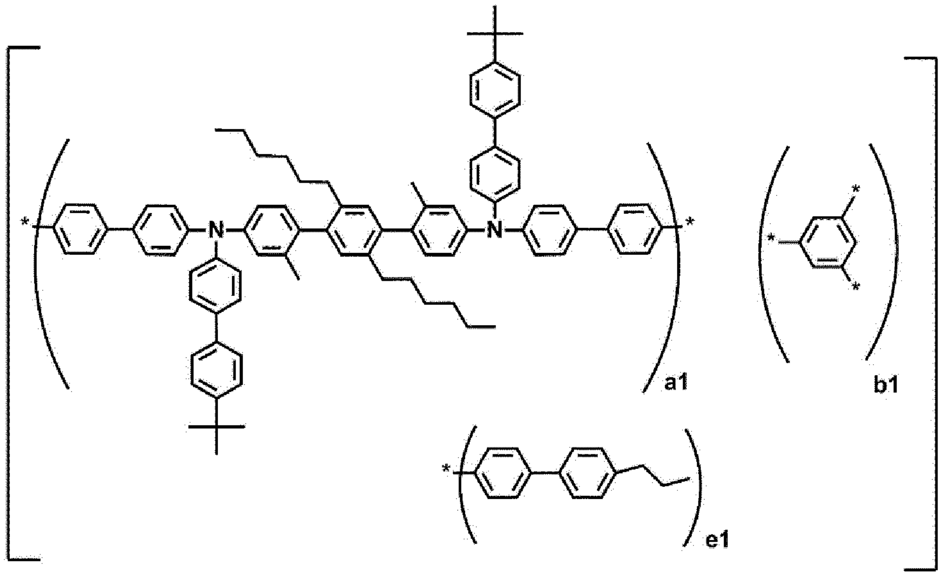

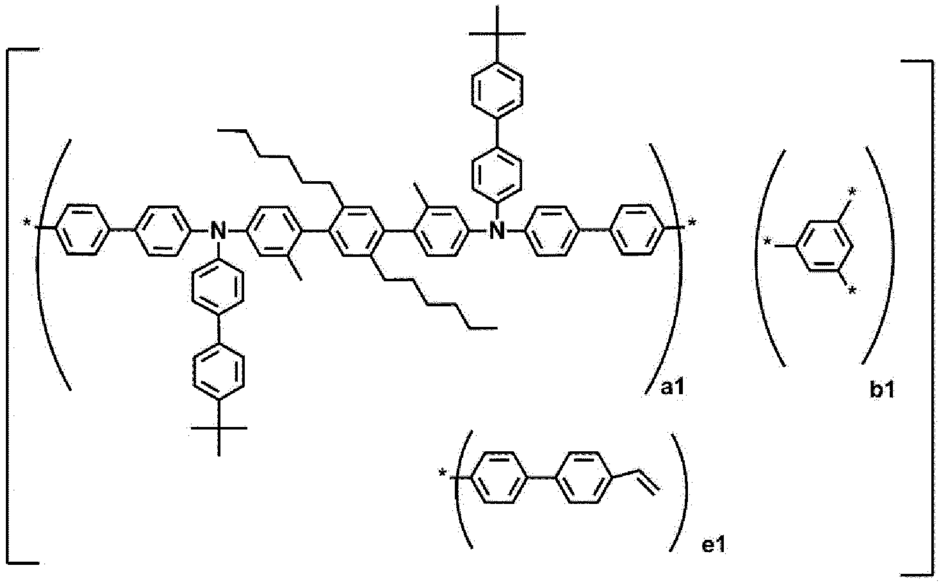

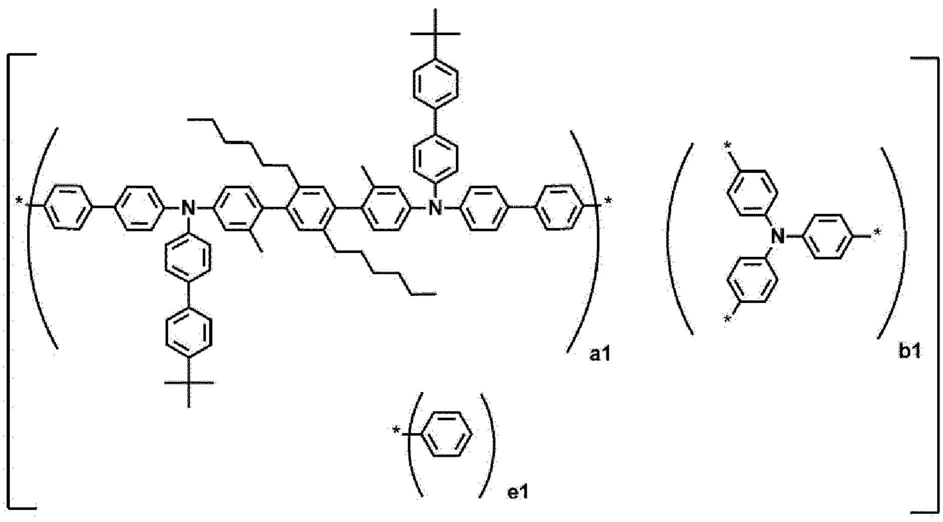

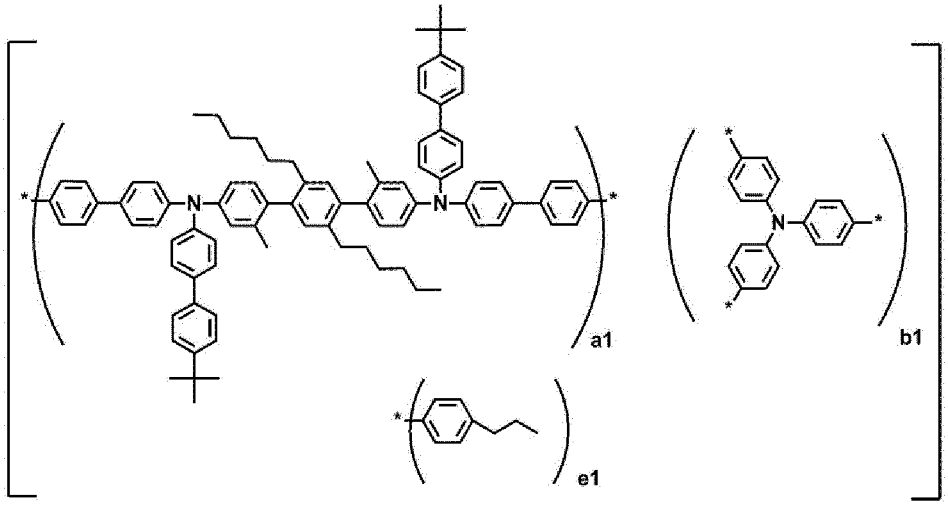

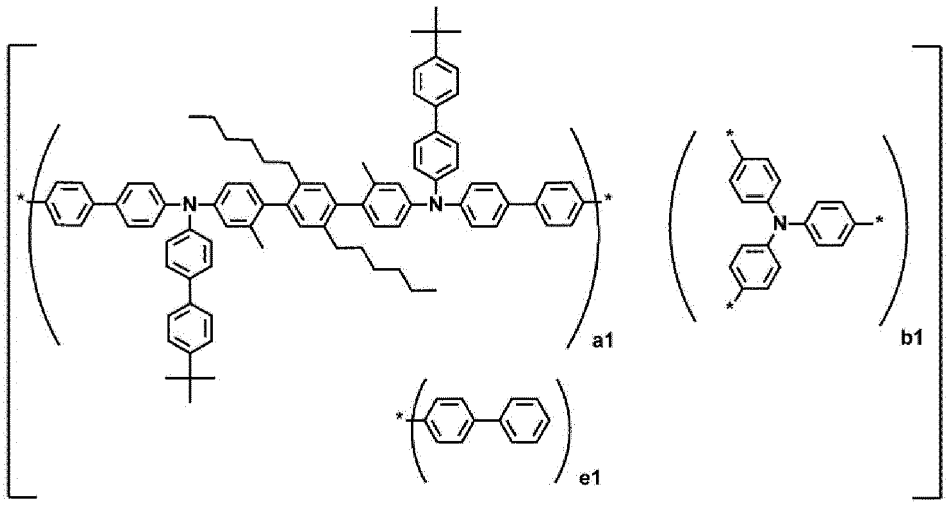

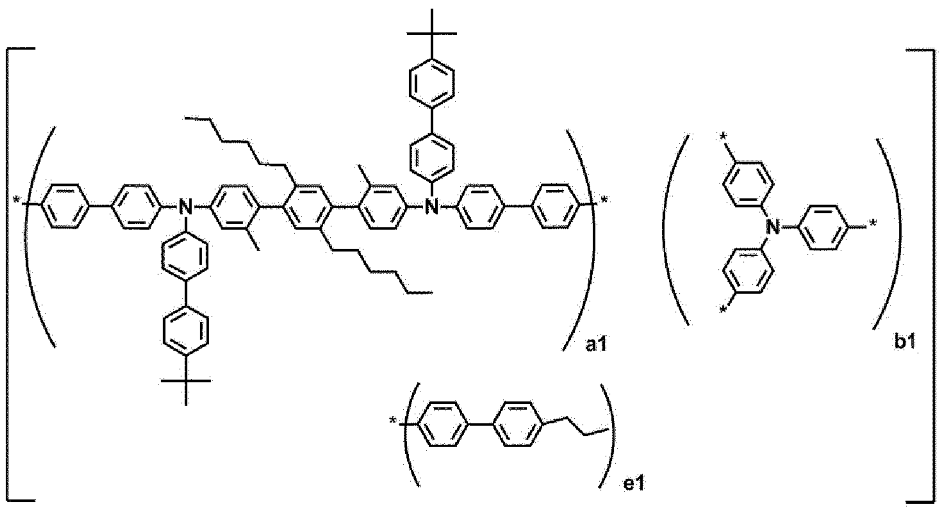

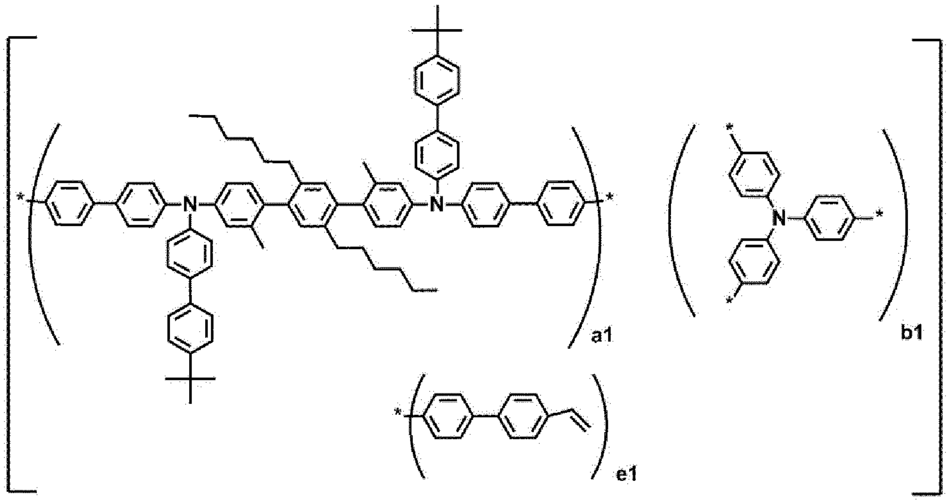

In the structures, a1 is a real number of 0<a1<1, b1 is a real number of 0≤b1<1, e1 is a real number of 0<e1<1, and al+bl+el is 1.

Specifically, in the structures, a1 is a real number of 0.4 to 0.9, b1 is a real number of 0.1 to 0.4, e1 is a real number of 0.1 to 0.5, and al+bl+el is 1.

More specifically, in the structures, a1 is a real number of 0.4 to 0.8, b1 is a real number of 0.1 to 0.4, e1 is a real number of 0.1 to 0.5, and al+bl+el is 1.

In the structures, a1, b1 and e1 are determined by an equivalent ratio of monomers introduced when preparing the polymer.

In one embodiment of the present specification, the polymer may be prepared using known polymerization techniques. For example, preparation methods such as Suzuki, Yamamoto, Stille, metal catalyst-using C-N coupling reaction and metal catalyst-using arylation reaction may be used.

In one embodiment of the present specification, the polymer may be substituted with deuterium. Herein, the polymer may be substituted with deuterium by applying a method of using a precursor material. For example, the polymer may be substituted with deuterium by treating an undeuterated monomer and/or polymer with a deuterated solvent under the presence of a Lewis acid H/D exchange catalyst.

In one embodiment of the present specification, the polymer may have the molecular weight controlled by adjusting a ratio of used monomers. In addition, in some embodiments, the polymer may have the molecular weight controlled using a quenching reaction.

In one embodiment of the present specification, the polymer may be used as a hole transfer material. For example, the polymer may be a 'polymer for hole transfer'.

In one embodiment of the present specification, the polymer may be formed to a layer through a solution process. The term 'layer' is interchangeably used with a term 'film', and refers to coating that covers a target area. This term is not limited by a size. The area may be as large as a whole device, may be as small as a specific functional area such as an actual visual display, or may be as small as a single subpixel. A layer and a film may be formed using any common deposition technique including vapor deposition, liquid deposition (continuous and discontinuous technique) and thermal transfer. The continuous deposition technique includes spin coating, gravure coating, curtain coating, dip coating, slot-die coating, spray coating and continuous nozzle coating, but is not limited thereto. The discontinuous deposition technique includes inkjet printing, gravure printing and screen printing, but is not limited thereto.

In one embodiment of the present specification, the polymer has intrinsic viscosity of less than 60 mL/g. This is particularly useful for inkjet printing applications, which allows spraying of a more concentrated solution due to lower viscosity. Specifically, the polymer has intrinsic viscosity of less than 50 mL/g, more specifically less than 40 mL/g, and more specifically less than 30 mL/g.

In one embodiment of the present specification, the polymer has intrinsic viscosity of greater than or equal to 20 mL/g and less than 60 mL/g, specifically 20 mL/g to 50 mL/g, and more specifically 20 mL/g to 40 mL/g.

One embodiment of the present specification provides a coating composition including the polymer described above.

In one embodiment of the present specification, the coating composition further includes a solvent. In one embodiment of the present specification, the coating composition includes the polymer and a solvent.

In one embodiment of the present specification, the coating composition may be a liquid phase. The "liquid phase" means being in a liquid state at room temperature and atmospheric pressure.

In one embodiment of the present specification, the solvent does not preferably dissolve materials used in lower layers.

In one embodiment of the present specification, when the coating composition is used in an organic material layer of an organic light emitting device, a solvent that does not dissolve materials of lower layers is used. For example, when the coating composition is used in a hole transfer layer, a solvent that does not dissolve materials of lower layers (first electrode, hole injection layer and the like) is used. Accordingly, an advantage of introducing a hole transfer layer using a solution process is obtained.

In one embodiment of the present specification, the coating composition has enhanced solvent resistance when conducting heat treatment after coating.

For example, even when preparing the coating composition using a solvent dissolving the polymer and preparing a layer using a solution process, resistance may be obtained for the same solvent after heat treatment.

Accordingly, when going through a heat treatment process after forming an organic material layer using the polymer, a solution process may be used when using other organic material layers.

In one embodiment of the present specification, examples of the solvent included in the coating composition may include chlorine-based solvents such as chloroform, methylene chloride, 1,2-dichloroethane, 1,1,2-trichloroethane, chlorobenzene and o-dichlorobenzene; ether-based solvents such as tetrahydrofuran and dioxane; aromatic hydrocarbon-based solvents such as toluene, xylene, trimethylbenzene and mesitylene; ketone-based solvents such as acetone, methyl ethyl ketone and cyclohexanone; ester-based solvents such as ethyl acetate, butyl acetate and ethyl cellosolve acetate; polyalcohols such as ethylene glycol, ethylene glycol monobutyl ether, ethylene glycol monoethyl ether, ethylene glycol monomethyl ether, dimethoxyethane, propylene glycol, diethoxymethane, triethylene glycol monoethyl ether, glycerin and 1,2-hexanediol, and derivatives thereof; alcohol-based solvents such as methanol, ethanol, propanol, isopropanol and cyclohexanol; sulfoxide-based solvents such as dimethyl sulfoxide; amide-based solvents such as N-methyl-2-pyrrolidone and N,N-dimethylformamide; benzoate-based solvents such as methyl benzoate, butyl benzoate and 3-phenoxybenzoate; tetraline, and the like, however, the solvent is not limited thereto as long as it is a solvent capable of dissolving or dispersing the polymer according to one embodiment of the present specification.

In one embodiment of the present specification, the solvent may be used either alone as one type, or as a mixture of two or more solvent types.

In one embodiment of the present specification, a boiling point of the solvent is preferably from 40°C to 350°C and more preferably from 80°C to 330°C, but is not limited thereto.

In one embodiment of the present specification, a concentration of the polymer in the coating composition is preferably from 0.1 wt/v% to 20 wt/v% and more preferably from 0.5 wt/v% to 10 wt/v%, but is not limited thereto.

One embodiment of the present specification provides an organic light emitting device including a first electrode; a second electrode provided opposite to the first electrode; and one or more organic material layers provided between the first electrode and the second electrode, wherein one or more layers of the organic material layers include the polymer.

The organic material layer of the organic light emitting device of the present specification may be formed in a single layer structure, but may be formed in a multilayer structure in which two or more organic material layers are laminated. For example, the organic light emitting device of the present disclosure may have a structure including a hole injection layer, a hole transfer layer, a light emitting layer, an electron transfer layer, an electron injection layer, a layer carrying out hole injection and transfer at the same time, a layer carrying out electron injection and transfer at the same time, and the like as the organic material layer. However, the structure of the organic light emitting device is not limited thereto, and may include a smaller number of organic layers.

When the organic light emitting device includes a plurality of organic material layers, the organic material layers may be formed with materials the same as or different from each other.

In one embodiment of the present specification, the organic light emitting device includes a first electrode; a second electrode provided opposite to the first electrode; and a light emitting layer provided between the first electrode and the second electrode, and further includes a single organic material layer between the light emitting layer and the first electrode, wherein the organic material layer includes the polymer.

In one embodiment of the present specification, the organic light emitting device includes a first electrode; a second electrode provided opposite to the first electrode; and a light emitting layer provided between the first electrode and the second electrode, and further includes multiple organic material layers between the light emitting layer and the first electrode, wherein one or more layers of the organic material layers include the polymer.

In one embodiment of the present specification, the organic light emitting device includes a first electrode; a second electrode provided opposite to the first electrode; and a light emitting layer provided between the first electrode and the second electrode, and further includes one or more of a hole injection layer, a hole transfer layer and an electron blocking layer between the light emitting layer and the first electrode, wherein one or more layers of the hole injection layer, the hole transfer layer and the electron blocking layer include the polymer.

In one embodiment of the present specification, the organic light emitting device includes a first electrode; a second electrode provided opposite to the first electrode; and a light emitting layer provided between the first electrode and the second electrode

and the second electrode, and further includes a hole injection layer and a hole transfer layer between the first electrode and the light emitting layer, wherein one or more layers of the hole injection layer and the hole transfer layer include the polymer.

In one embodiment of the present specification the organic light emitting device has a structure in which a first electrode; a hole injection layer; a hole transfer layer; a light emitting layer; and a second electrode are consecutively provided, and one or more layers of the hole injection layer and the hole transfer layer include the polymer.

In one embodiment of the present specification, the organic light emitting device has a structure in which a first electrode; a hole injection layer; a hole transfer layer; a light emitting layer; and a second electrode are consecutively laminated, and the hole injection layer or the hole transfer layer includes the polymer.

In one embodiment of the present specification, the organic light emitting device has a structure in which a first electrode; a hole injection layer; a hole transfer layer; a light emitting layer; and a second electrode are consecutively laminated, and the hole injection layer includes the polymer.

In one embodiment of the present specification, an additional organic material layer may be further included between the light emitting layer and the second electrode.

In one embodiment of the present specification, a single organic material layer may be further included between the light emitting layer and the second electrode.

In one embodiment of the present specification, multiple organic material layers may be further included between the light emitting layer and the second electrode. For example, one or more layers of a hole blocking layer, an electron injection layer, an electron transfer layer and a layer carrying out electron injection and transfer at the same time may be further included between the light emitting layer and the second electrode.

In one embodiment of the present specification, the organic light emitting device has a structure in which a first electrode; a hole injection layer; a hole transfer layer; a light emitting layer; an electron injection and transfer layer; and a second electrode are consecutively laminated, and one or more layers of the hole injection layer and the hole transfer layer include the polymer.

In one embodiment of the present specification, the organic light emitting device has a structure in which a first electrode; a hole injection layer; a hole transfer layer; a light emitting layer; an electron injection and transfer layer; and a second electrode are consecutively laminated, and the hole injection layer or the hole transfer layer includes the polymer.

In one embodiment of the present specification, the organic light emitting device has a structure in which a first electrode; a hole injection layer; a hole transfer layer; a light emitting layer; an electron injection and transfer layer; and a second electrode are consecutively laminated, and the hole injection layer includes the polymer.

In one embodiment of the present specification, the organic light emitting device has a structure in which a first electrode; a hole injection layer; a hole transfer layer; a light emitting layer; an electron injection and transfer layer; and a second electrode are consecutively laminated, and the hole transfer layer includes the polymer.

For example, a structure of the organic light emitting device according to one embodiment of the present specification is illustrated in FIG. 1.

FIG. 1 illustrates a structure of the organic light emitting device in which a substrate (1), an anode (2), a light emitting layer (3) and a cathode (4) are consecutively laminated.

FIG. 2 illustrates a structure of the organic light emitting device in which a substrate (1), an anode (2), a hole injection layer (5), a hole transfer layer (6), a light emitting layer (3), an electron injection and transfer layer (7) and a cathode (4) are consecutively laminated.

FIG. 1 and FIG. 2 only illustrate the organic light emitting device, and the structure of the organic light emitting device of the present disclosure is not limited thereto.

In one embodiment of the present specification, the first electrode is an anode, and the second electrode is a cathode. In another embodiment, the first electrode is a cathode, and the second electrode is an anode.

In another embodiment, the organic light emitting device may be an organic light emitting device having a structure in which an anode, one or more organic material layers and a cathode are consecutively laminated on a substrate (normal type).

In another embodiment, the organic light emitting device may be an organic light emitting device having a structure in a reverse direction in which a cathode, one or more organic material layers and an anode are consecutively laminated on a substrate (inverted type).

The organic light emitting device of the present disclosure may be laminated in structures as illustrated below.

(1) an anode/a hole transfer layer/a light emitting layer/a cathode
(2) an anode/a hole injection layer/a hole transfer layer/a light emitting layer/a cathode
(3) an anode/a hole injection layer/a hole buffer layer/a hole transfer layer/a light emitting layer/a cathode
(4) an anode/a hole transfer layer/a light emitting layer/an electron transfer layer/a cathode

(5) an anode/a hole transfer layer/a light emitting layer/an electron transfer layer/an electron injection layer/a cathode
(6) an anode/a hole injection layer/a hole transfer layer/a light emitting layer/an electron transfer layer/a cathode
(7) an anode/a hole injection layer/a hole transfer layer/a light emitting layer/an electron transfer layer/an electron injection layer/a cathode
(8) an anode/a hole injection layer/a hole buffer layer/a hole transfer layer/a light emitting layer/an electron transfer layer/a cathode
(9) an anode/a hole injection layer/a hole buffer layer/a hole transfer layer/a light emitting layer/an electron transfer layer/an electron injection layer /a cathode
(10) an anode/a hole transfer layer/an electron blocking layer/a light emitting layer/an electron transfer layer/a cathode
(11) an anode/a hole transfer layer/an electron blocking layer/a light emitting layer/an electron transfer layer/an electron injection layer/a cathode
(12) an anode/a hole injection layer/a hole transfer layer/an electron blocking layer/a light emitting layer/an electron transfer layer/a cathode
(13) an anode/a hole injection layer/a hole transfer layer/an electron blocking layer/a light emitting layer/an electron transfer layer/an electron injection layer/a cathode
(14) an anode/a hole transfer layer/a light emitting layer/a hole blocking layer/an electron transfer layer/a cathode
(15) an anode/a hole transfer layer/a light emitting layer/a hole blocking layer/an electron transfer layer/an electron injection layer/a cathode
(16) an anode/a hole injection layer/a hole transfer layer/a light emitting layer/a hole blocking layer/an electron transfer layer/a cathode
(17) an anode/a hole injection layer/a hole transfer layer/a light emitting layer/a hole blocking layer/an electron transfer layer/an electron injection layer/a cathode
(18) an anode/a hole injection layer/a hole transfer layer/an electron blocking layer/a light emitting layer/a hole blocking layer/an electron injection layer and transfer layer/a cathode

In the structures, the "an electron transfer layer/an electron injection layer" may be replaced by the "an electron injection and transfer layer".

The organic light emitting device of the present specification may be manufactured using materials and methods known in the art except for preparing one or more layers of the organic material layers to include the polymer. Specifically, in the organic light emitting device, one or more layers of the organic material layers may be formed using the coating composition including the polymer.

For example, the organic light emitting device of the present specification may be manufactured by consecutively laminating an anode, an organic material layer and a cathode on a substrate. Herein, the organic light emitting device may be manufactured by forming an anode on a substrate by depositing a metal, a metal oxide having conductivity, or an alloy thereof using a physical vapor deposition (PVD) method such as sputtering or e-beam evaporation, forming an organic material layer including a hole injection layer, a hole transfer layer, a light emitting layer, an electron injection and transfer layer thereon, and then depositing a material usable as a cathode thereon. In addition to such a method, the organic light emitting device may also be manufactured by consecutively depositing a cathode material, an organic material layer and an anode material on a substrate.

In addition, one embodiment of the present specification provides a method for manufacturing an organic light emitting device formed using the coating composition.

Specifically, the method of one embodiment of the present specification includes preparing a substrate; forming a first electrode on the substrate; forming one or more organic material layers on the first electrode; and forming a second electrode on the organic material layer, wherein one or more layers of the organic material layers are formed using the coating composition.

In one embodiment of the present specification, the organic material layer formed using the coating composition is formed using spin coating.

In another embodiment, the organic material layer formed using the coating composition is formed using a printing method.

In an embodiment of the present specification, examples of the printing method include inkjet printing, nozzle printing, offset printing, transfer printing, screen printing or the like, but are not limited thereto.

The coating composition according to one embodiment of the present specification is suited for a solution process due to its structural properties and may be formed using a printing method, and therefore, is economically effective in terms of time and costs when manufacturing a device.

In one embodiment of the present specification, the forming of organic material layers using the coating composition includes coating the coating composition on the first electrode; and heat treating or light treating the coated coating composition.

In another embodiment, the time of heat treatment in the heat treating may be within 1 hour. Specifically, the

time may be within 30 minutes.

In one embodiment of the present specification, the atmosphere of heat treating the organic material layer formed using the coating composition is preferably an inert gas atmosphere such as argon or nitrogen.

When the organic material layer formed using the coating composition is formed including the heat treating or light treating, multilayers may be formed by repeatedly conducting solution depositing and crosslinking methods due to increased resistance for the solvent, and device lifetime properties may be enhanced by increasing stability.

In one embodiment of the present specification, the organic material layer including the polymer is a hole injection layer, a hole transfer layer, or a layer carrying out hole injection and hole transfer at the same time.

In one embodiment of the present specification, the first electrode is an anode, and the second electrode is a cathode.

According to another embodiment, the first electrode is a cathode, and the second electrode is an anode.

In one embodiment of the present specification, as the anode material, materials having large work function are normally preferred so that hole injection to an organic material layer is smooth. Specific examples of the anode material usable in the present disclosure include metals such as vanadium, chromium, copper, zinc and gold, or alloys thereof; metal oxides such as zinc oxide, indium oxide, indium tin oxide (ITO) and indium zinc oxide (IZO); combinations of metals and oxides such as ZnO:Al or $SnO_2$:Sb; conductive polymers such as poly(3-methylthiophene), poly[3,4-(ethylene-1,2-dioxy)thiophene] (PEDOT), polypyrrole and polyaniline, and the like, but are not limited thereto.

In one embodiment of the present specification, as the cathode material, materials having small work function are normally preferred so that electron injection to an organic material layer is smooth. Specific examples of the cathode material include metals such as magnesium, calcium, sodium, potassium, titanium, indium, yttrium, lithium, gadolinium, aluminum, silver, tin and lead, or alloys thereof; multilayer structure materials such as LiF/Al or $LiO_2$/Al, and the like, but are not limited thereto.

In one embodiment of the present specification, the hole injection layer is a layer that injects holes from an electrode, and the hole injection material is preferably a compound that has an ability to transfer holes and thereby has a hole injection effect in an anode and an excellent hole injection effect for a light emitting layer or a light emitting material, prevents excitons generated in the light emitting layer from moving to an electron injection layer or an electron injection material, and has an excellent thin film forming ability. In addition, the highest occupied molecular orbital (HOMO) of the hole injection material is preferably in between the work function of an anode material and the HOMO of surrounding organic material layers. Specific examples of the hole injection material include metal porphyrins, oligothiophene, arylamine-based organic materials, hexanitrile hexaazatriphenylene-based organic materials, quinacridone-based organic materials, perylene-based organic materials, anthraquinone, and polyaniline- and polythiophene-based conductive polymers, and the like, but are not limited thereto.

In one embodiment of the present specification, the hole transfer layer is a layer that receives holes from a hole injection layer and transfers the holes to a light emitting layer, and as the hole transfer material, materials capable of receiving holes from an anode or a hole injection layer, moving the holes to a light emitting layer, and having high mobility for the holes are suited. In one embodiment of the present specification, the hole transfer layer includes the polymer.

In one embodiment of the present specification, the light emitting layer includes an organic compound. The organic compound is a material capable of emitting light in a visible region by receiving holes and electrons from a hole transfer layer and an electron transfer layer, respectively, and binding the holes and the electrons, and is preferably a material having favorable quantum efficiency for fluorescence or phosphorescence. Specific examples thereof include 8-hydroxyquinoline aluminum complexes ($Alq_3$); carbazole-based compounds; dimerized styryl compounds; BAlq; 10-hydroxybenzoquinoline-metal compounds; benzoxazole-, benzothiazole- and benzimidazole-based compounds; poly(p-phenylenevinylene) (PPV)-based polymers; spiro compounds; polyfluorene, rubrene, and the like, but are not limited thereto.

In one embodiment of the present specification, the light emitting layer may include a host material and a dopant material. The host material includes fused aromatic ring derivatives, heteroring-containing compounds or the like. Examples of the fused aromatic ring derivative include anthracene derivatives, pyrene derivatives, naphthalene derivatives, pentacene derivatives, phenanthrene compounds, fluoranthene compounds and the like, and examples of the heteroring-containing compound include carbazole derivatives, dibenzofuran derivatives, ladder-type furan compounds, pyrimidine derivatives and the like, however, the fused aromatic ring derivative and the heteroring-containing compound are not limited thereto. The dopant material includes aromatic amine derivatives, styrylamine compounds, boron complexes, fluoranthene compounds, metal complexes and the like. For example, the aromatic amine derivative is a fused aromatic ring derivative substituted with a substituted or unsubstituted arylamino group, and examples thereof include arylamino group-substituted fluorene, benzofluorene, pyrene, anthracene, chrysene, peryflanthene and the like. The styrylamine compound is a compound in which substituted or unsubstituted arylamine is substituted with at least one arylvinyl group, and the compound is unsubstituted or substituted with one, two or more substituents selected from the group consisting of an aryl group, a silyl group, an alkyl group, a cycloalkyl group and an arylamino group. Specifically, examples of the

styrylamine compound include styrylamine, styryldiamine, styryltriamine, styryltetramine and the like, however, the styrylamine compound is not limited thereto. In addition, the metal complex includes iridium complexes, platinum complexes or the like, but is not limited thereto.

In one embodiment of the present specification, the host material is an anthracene derivative, and the dopant material is a benzofluorene-based compound substituted with an arylamine group. Specifically, the host material is a deuterated anthracene derivative, and the dopant material is a bis(diarylamino)benzofluorene-based compound.

In one embodiment of the present specification, the light emitting layer includes quantum dots. For example, the light emitting layer includes a matrix resin and quantum dots, and as type and content of the quantum dots, those known in the art may be used.

When the light emitting layer includes quantum dots, a lower HOMO energy level is obtained compared to when the light emitting layer includes an organic compound, and a common layer also needs to have a low HOMO energy level. By the compound according to one embodiment of the present specification including a halogen group, a low HOMO energy level is obtained, and therefore, quantum dots may be introduced to the light emitting layer.

In one embodiment of the present specification, the common layer is a hole injection layer, a hole transfer layer, a layer carrying out hole injection and hole transfer at the same time, an electron injection layer, an electron transfer layer, or a layer carrying out electron injection and electron transfer at the same time.

In one embodiment of the present specification, the electron transfer layer is a layer that receives electrons from an electron injection layer and transfers the electrons to a light emitting layer, and as the electron transfer material, materials capable of favorably receiving electrons from a cathode, moving the electrons to a light emitting layer, and having high mobility for the electrons are suited. Specific examples thereof include Al complexes of 8-hydroxyquinoline; complexes including $Alq_3$; organic radical compounds; hydroxyflavon-metal complexes, or the like, but are not limited thereto. The electron transfer layer may be used together with any desired cathode material as used in the art. Particularly, examples of the suitable cathode material include common materials that have small work function, and in which an aluminum layer or a silver layer follows. Specifically, the cathode material includes cesium, barium, calcium, ytterbium and samarium, and in each case, an aluminum layer or a silver layer follows.

In one embodiment of the present specification, the electron injection layer is a layer that injects electrons from an electrode, and the electron injection material is preferably a compound that has an ability to transfer electrons, has an electron injection effect from a cathode, has an excellent electron injection effect for a light emitting layer or a light emitting material, prevents excitons generated in the light emitting layer from moving to a hole injection layer, and in addition thereto, has an excellent thin film forming ability. Specific examples thereof include fluorenone, anthraquinodimethane, diphenoquinone, thiopyran dioxide, oxazole, oxadiazole, triazole, imidazole, perylene tetracarboxylic acid, fluorenylidene methane, anthrone, bathocuproine (BCP) or the like, and derivatives thereof, metal complex compounds, nitrogen-containing 5-membered ring derivatives, and the like, but are not limited there.

In one embodiment of the present specification, the metal complex compound includes 8-hydroxyquinolinato lithium, bis (8-hydroxyquinolinato)zinc, bis(8-hydroxyquinolinato)copper, bis(8-hydroxyquinolinato)manganese, tris(8-hydroxyquinolinato)aluminum, tris(2-methyl-8-hydroxyquinolinato)aluminum, tris(8-hydroxyquinolinato)gallium, bis(10-hydroxybenzo[h]quinolinato)beryllium, bis(10-hydroxybenzo[h]quinolinato)zinc, bis(2-methyl-8-quinolinato)chlorogallium, bis(2-methyl-8-quinolinato) (o-cresolato)gallium, bis(2-methyl-8-quinolinato)(1-naphtholato)aluminum, bis(2-methyl-8-quinolinato)(2-naphtholato)gallium and the like, but is not limited thereto.

In one embodiment of the present specification, the hole blocking layer is a layer blocking holes from reaching a cathode, and may be generally formed under the same condition as a hole injection layer. Specific examples thereof may include oxadiazole derivatives or triazole derivatives, phenanthroline derivatives, BCP, aluminum complexes and the like, but are not limited thereto.

In one embodiment of the present specification, a layer adjacent to the organic material layer including the polymer represented by Chemical Formula 1; or the polymer including the unit represented by Chemical Formula 2 and the end group represented by Chemical Formula 5, for example, a bank layer, includes a compound having fluorine as a substituent.

For example, when the polymer represented by Chemical Formula 1 is included in a hole transfer layer, one or more of bank layers adjacent to the hole transfer layer, a hole injection layer and a light emitting layer, include fluorine.

When a layer adjacent to the organic material layer including the polymer represented by Chemical Formula 1; or the polymer including the unit represented by Chemical Formula 2 and the end group represented by Chemical Formula 5 includes fluorine as above, the dipole moment changes due to the fluorine, which is effective in forming a uniform layer.

The organic light emitting device according to the present specification may be a top-emission type, a bottom-emission type or a dual-emission type depending on the materials used.

Hereinafter, the present specification will be described in detail with reference to examples in order to specifically describe the present specification. However, the examples according to the present specification may be modified to various different forms, and the scope of the present application is not to be construed as being limited to the examples

described below. Examples of the present application are provided in order to more fully describe the present specification to those having average knowledge in the art.

Synthesis Example 1. Preparation of Polymer 1-1

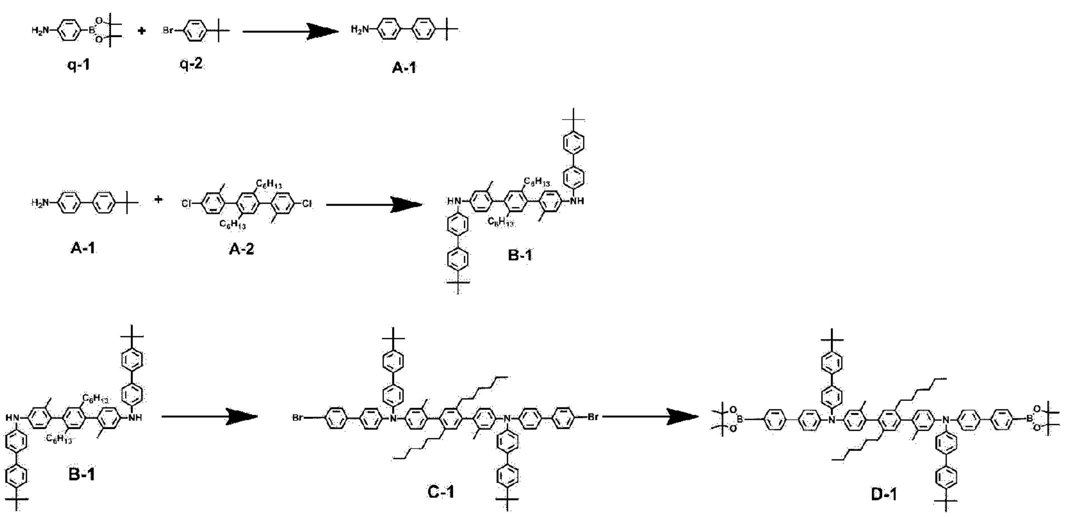

q-1 q-2 A-1

A-1 A-2 B-1

B-1 C-1 D-1

**(1)** Preparation of Compound A-1

To a condenser-equipped round flask, Compound q-1 (50.0 g, 1.00 eq.), Compound q-2 (65.2 g, 1.35 eq.), $K_2CO_3$ (78.7 g, 2.5 eq.) and bis(tri-tert-butylphosphine)palladium(0) (1.74 g, 0.015 eq.) were introduced, then tetrahydrofuran (THF) (500 mL) and distilled water (300 mL) were each injected thereto, and, after raising the temperature to 60°C, the mixture was stirred for 6 hours. The reaction was terminated by injecting distilled water thereto, and the organic solvent was extracted and then vacuum concentrated to prepare Compound A-1 (50.1 g) in a liquid state.

**(2) Preparation of Compound B-1**

In a condenser-equipped round flask, Compound A-1 (50.0 g, 3.0 eq.) prepared above and Compound A-2 (41.0 g, 1.00 eq.) were dissolved in xylene (200 mL). After the compounds were completely dissolved, sodium tert-butoxide (40.0 g, 5.00 eq.) and bis(tri-tert-butylphosphine)palladium(0) (2.1 g, 0.05 eq.) were introduced thereto, and the mixture was refluxed for 3 hours at 120°C. The reaction was terminated by injecting distilled water thereto, and the organic solvent was extracted with ethyl acetate and distilled water, and precipitated with toluene and hexane to obtain white solid Compound B-1.

**(3) Preparation of Compound C-1**

In a condenser-equipped round flask, Compound B-1 (15.1 g, 1.00 eq.) prepared above, 4-bromo-4'-iodo-1,1'-biphenyl (13.16 g, 2.50 eq.) and sodium tert-butoxide (7.0 g, 5.00 eq.) were dissolved in toluene (200 mL). After the compounds were completely dissolved, tris(dibenzylideneacetone)dipalladium(0) (0.67 g, 0.05 eq.) and 1,1'-bis(diphenylphosphino)ferrocene (0.81 g, 0.10 eq.) were introduced thereto, and the mixture was refluxed for 8 hours at 90°C. The reaction was terminated by injecting distilled water thereto, and the organic solvent was extracted with ethyl acetate and distilled water, and went through column chromatography to obtain 99.7% purity Compound C-1.

**(4) Preparation of Compound D-1**

In a condenser-equipped round flask, Compound C-1 (10.00 g, 1.00 eq.), bis(pinacolato)diboron (14 g, 2.00 eq.) and potassium tert-butoxide (1.60 g, 3.00 eq.) were dissolved in toluene (200 mL). After the compounds were completely dissolved, [1,1'-bis(diphenylphosphino)ferrocene]dichloropalladium(II) (0.20 g, 0.04 eq.) was introduced thereto, and the mixture was refluxed for 8 hours at 90°C. The reaction was terminated through DI water, and the organic solvent was extracted with ethyl acetate and distilled water, and went through column chromatography to obtain 99.3%

purity Compound D-1.

**(5) Preparation of Polymer 1-1**

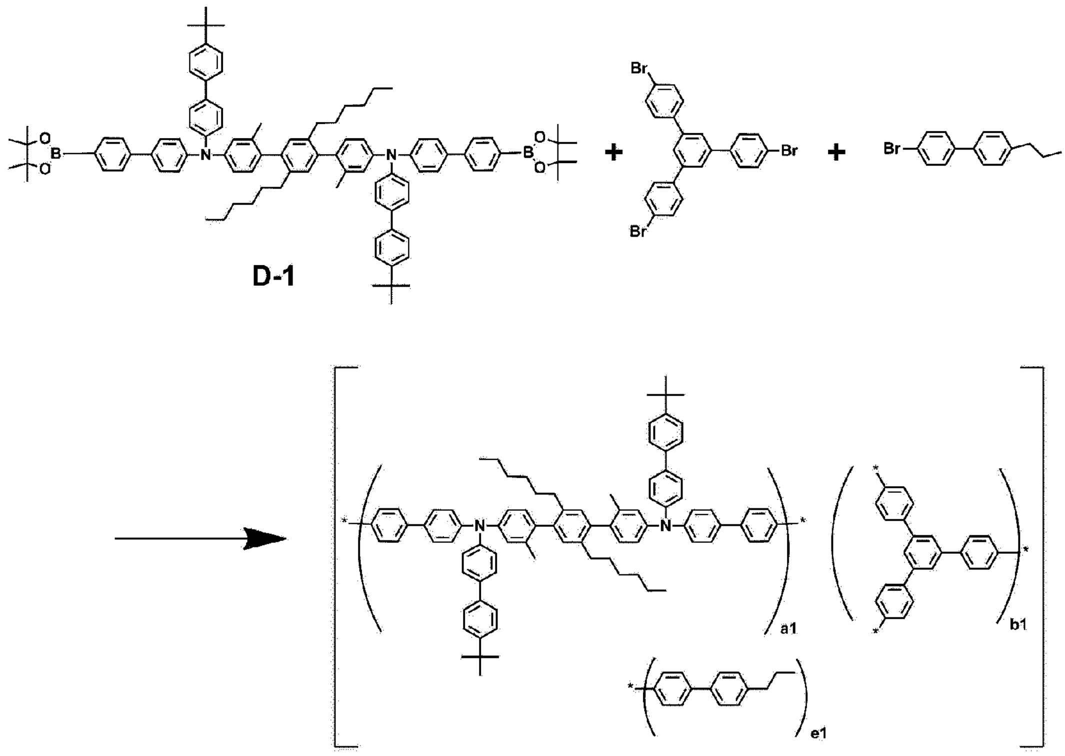

D-1

1-1

Compound D-1 (0.765 mmol), 4,4"-dibromo-5'-(4-bromophenyl)-1,1':3',1"-terphenyl (0.158 mmol) and 4-bromo-4'-propyl-1,1'-biphenyl (0.369 mmol) were introduced to a round flask, and dissolved in toluene (11 mL) to prepare a first solution.

To a 50 mL Schlenk tube, bis(1,5-cyclooctadiene)nickel(0) (2.42 mmol) was introduced. 2,2'-Dipyridyl (2.42 mmol) and 1,5-cyclooctadiene (2.42 mmol) were introduced to a scintillation vial, and dissolved in N,N'-dimethylformamide (5.5 mL) and toluene (11 mL) to prepare a second solution.

The second solution was introduced to the Schlenk tube, and stirred for 30 minutes at 50°C. The first solution was further added to the Schlenk tube, and the result was stirred for 3 hours at 50°C. HCl and methanol (methanol:HCl=95:5 (v:v)) were slowly added dropwise thereto to terminate the reaction, the result was stirred for 45 minutes, and produced solids were filtered. The dried solids were dissolved in toluene (1% wt/v), and passed through a column containing silica gel and basic aluminum oxide (each 6 g) for purification. The obtained toluene solution was triturated in acetone to prepare Polymer 1-1.

**Synthesis Example 2. Preparation of Polymer 2-1**

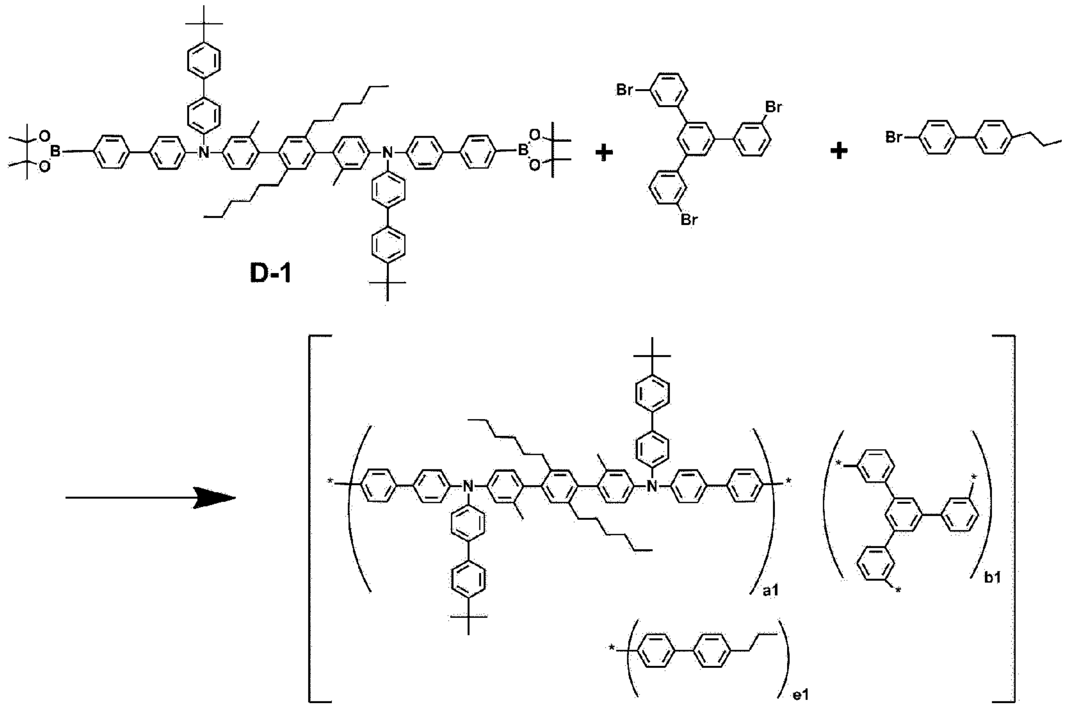

D-1

2-1

Polymer 2-1 was prepared in the same manner as in Synthesis Example 1 except that, in (5) of Synthesis Example 1, 3,3"-dibromo-5'-(3-bromophenyl)-1,1':3',1"-terphenyl was used instead of 4,4"-dibromo-5'-(4-bromophenyl)-1,1':3',1"-terphenyl.

**Synthesis Example 3. Preparation of Polymer 3-1**

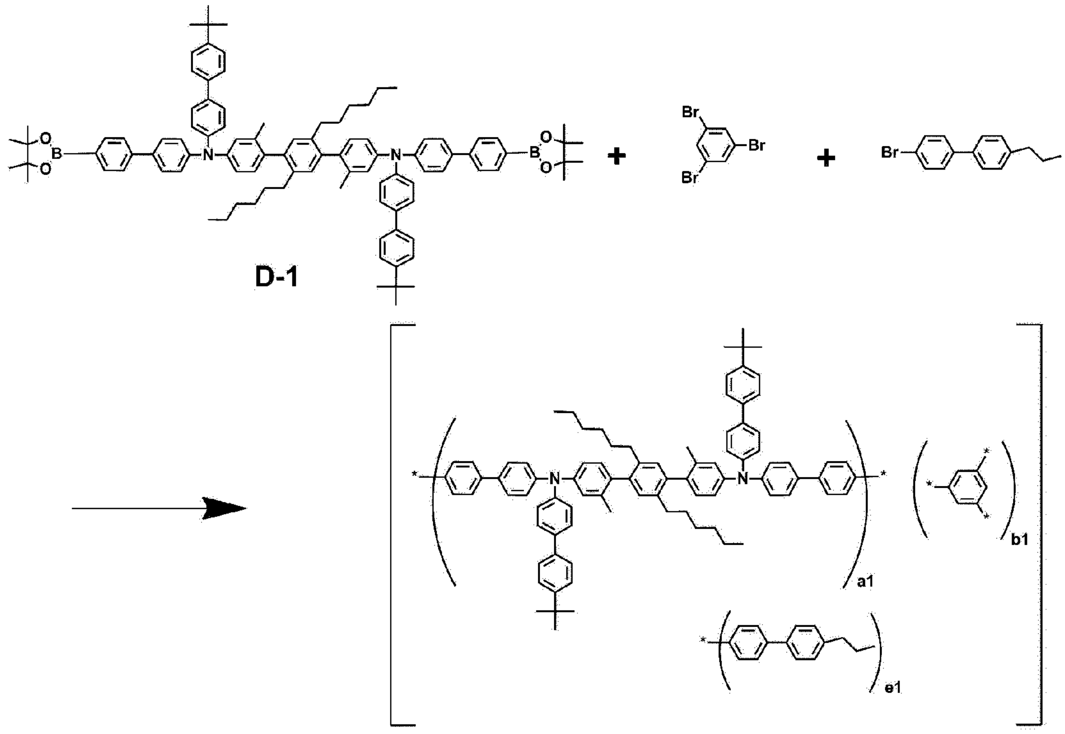

D-1

3-1

Polymer 3-1 was prepared in the same manner as in Synthesis Example 1 except that, in (5) of Synthesis Example 1, 1,3,5-tribromobenzene was used instead of 4,4"-dibromo-5'-(4-bromophenyl)-1,1':3',1"-terphenyl.

**Synthesis Example 4: Preparation of Polymer 4-1**

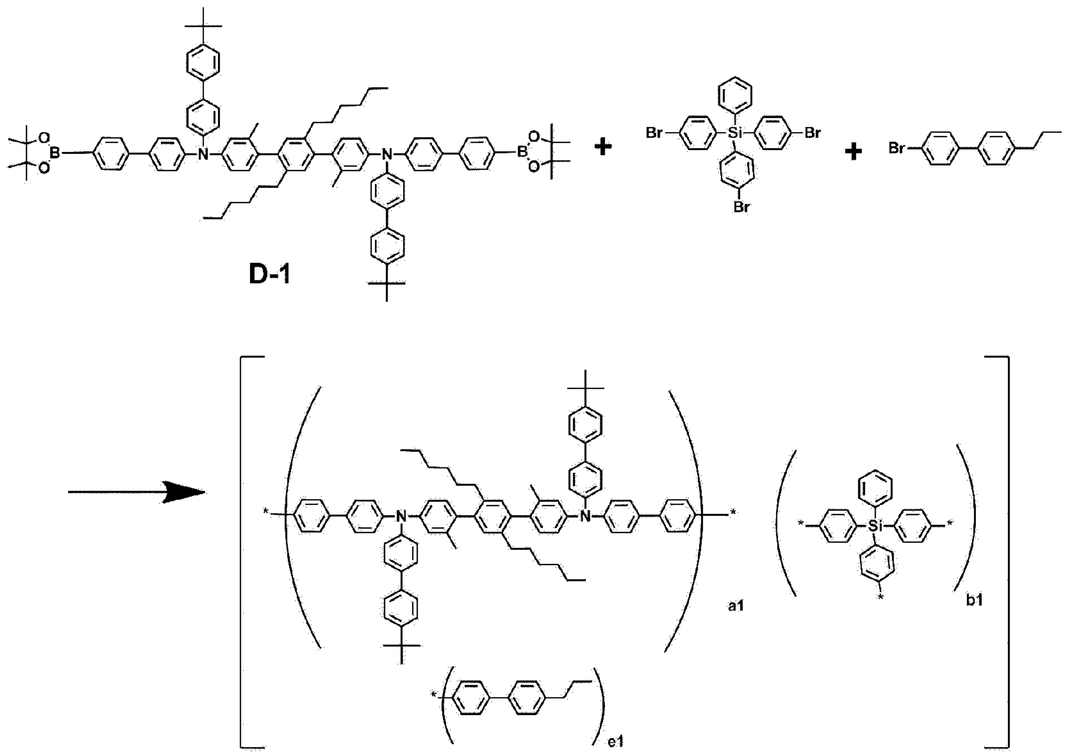

D-1

4-1

Polymer 4-1 was prepared in the same manner as in Synthesis Example 1 except that, in (5) of Synthesis Example 1, tris(4-bromophenyl)(phenyl)silane was used instead of 4,4"-dibromo-5'-(4-bromophenyl)-1,1':3',1"-terphenyl.

**Synthesis Example 5: Preparation of Polymer 5-1**

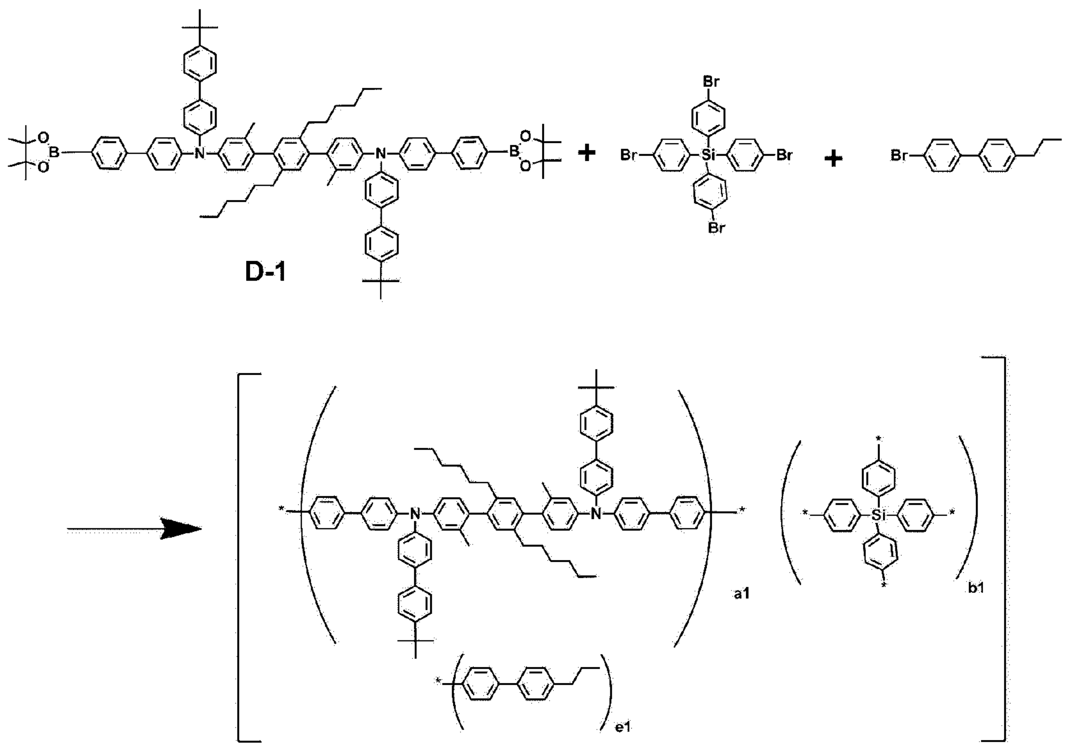

D-1

5-1

Polymer 5-1 was prepared in the same manner as in Synthesis Example 1 except that, in (5) of Synthesis Example 1, tetrakis(4-bromophenyl)silane was used instead of 4,4"-dibromo-5'-(4-bromophenyl)-1,1':3',1"-terphenyl.

**Synthesis Example 6: Preparation of Polymer 6-1**

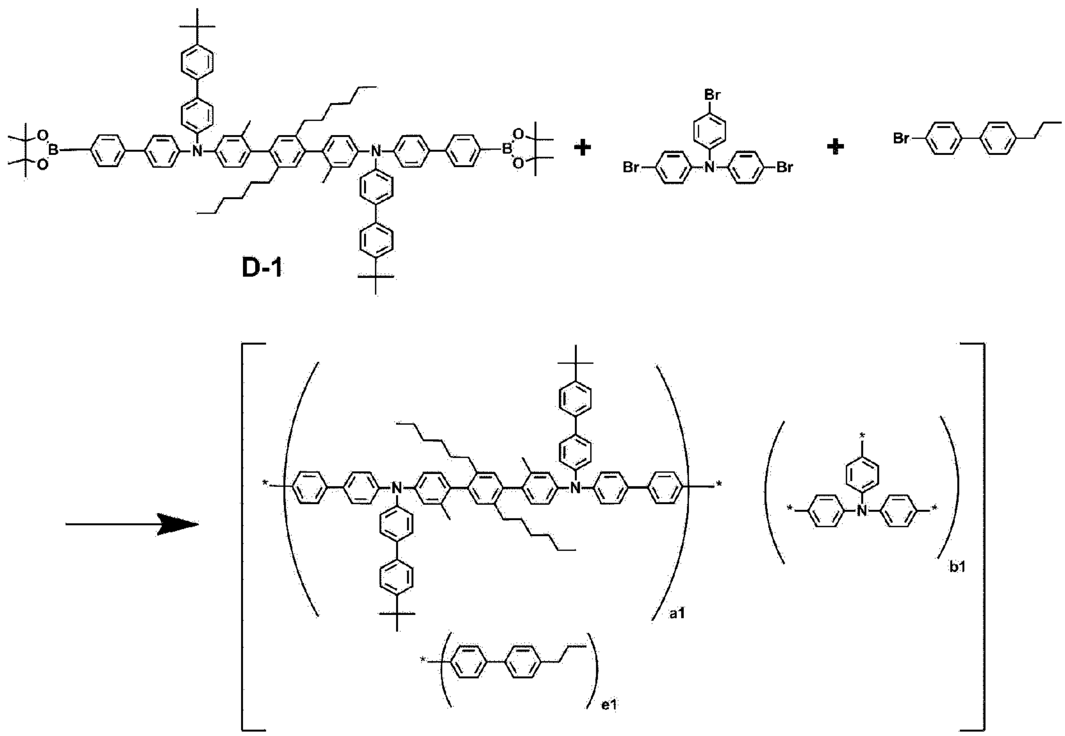

D-1

6-1

Polymer 6-1 was prepared in the same manner as in Synthesis Example 1 except that, in (5) of Synthesis Example 1, tris(4-bromophenyl)amine was used instead of 4,4"-dibromo-5'-(4-bromophenyl)-1,1':3',1"-terphenyl.

**Comparative Synthesis Example 1. Preparation of Comparative Polymer Q**

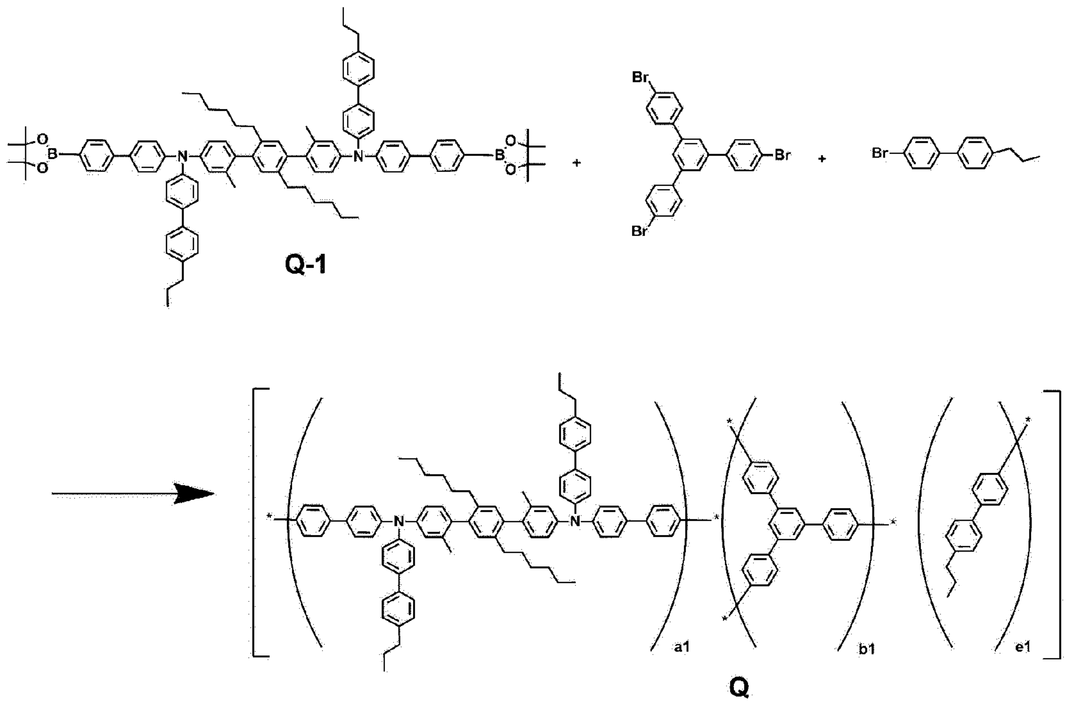

Q-1

Q

Polymer Q was prepared in the same manner as in (5) of Synthesis Example 1 except that Compound Q-1 was used instead of Compound D-1.

**Comparative Synthesis Example 2. Preparation of Comparative Polymer W**

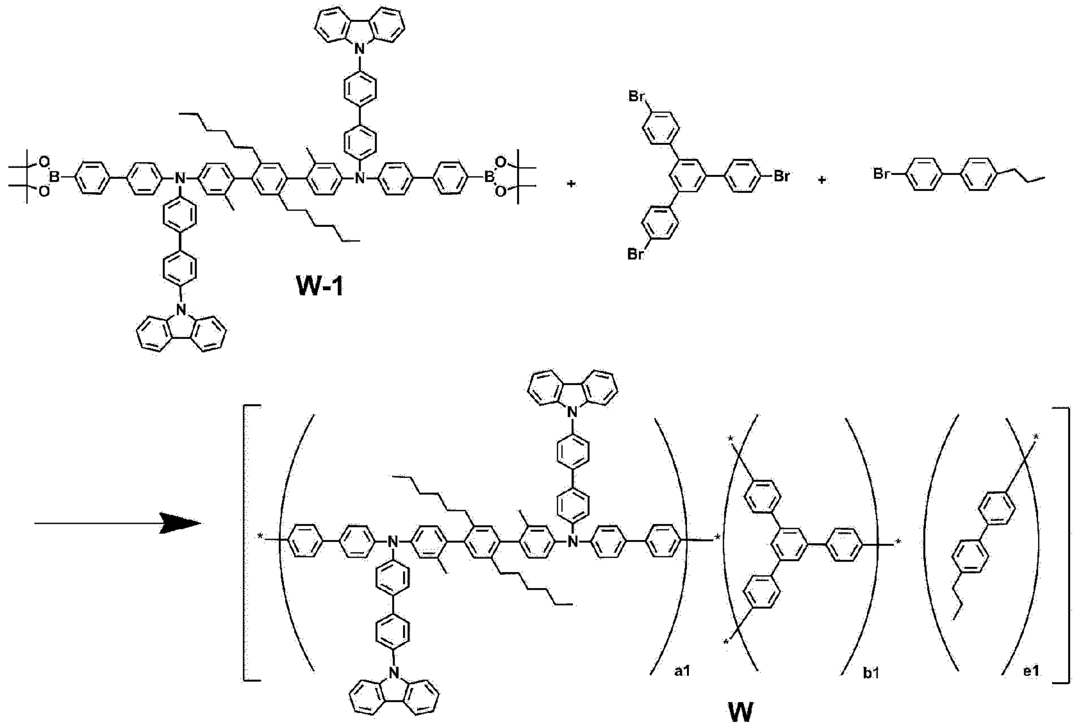

W-1

W

Polymer W was prepared in the same manner as in (5) of Synthesis Example 1 except that Compound W-1 was used instead of Compound D-1.

**<Experimental Example 1> Measurement of Molecular Weight Distribution**

**Experimental Example 1-1.**

Peak molecular weight (Mp), number average molecular weight (Mn), weight average molecular weight (Mw) and molecular weight distribution (PDI) of Polymer 1-1 prepared in Synthesis Example 1 were measured using GPC (Agilent Technologies, Inc., PLgel HFIPGEL column). Herein, the peak molecular weight (Mp) means a molecular weight most frequently distributed.

**Experimental Examples 1-2 to 1-6.**

Peak molecular weights (Mp), number average molecular weights (Mn), weight average molecular weights (Mw) and molecular weight distributions (PDI) were measured in the same manner as in Experimental Example 1-1 except that polymers of the following Table 1 were used instead of Polymer 1-1.

**Comparative Examples 1-1 and 1-2.**

Peak molecular weights (Mp), number average molecular weights (Mn), weight average molecular weights (Mw) and molecular weight distributions (PDI) were measured in the same manner as in Experimental Example 1-1 except that polymers of the following Table 1 were used instead of Polymer 1-1.

GPC results measured in Experimental Examples 1-1 to 1-6, and Comparative Examples 1-1 and 1-2 are shown in the following Table 1.

In addition, GPC results measured in Experimental Example 1-1 and Comparative Example 1-1 are shown in

FIG. 3. In FIG. 3, (a) shows the result of GPC measurement in Comparative Example 1-1 (Polymer Q), and (b) to (d) each show the result of GPC measurements in Experimental Example 1-1 (Polymer 1-1).

Equation (1): PDI=weight average molecular weight (Mw)/number average molecular weight (Mn)

[Table 1]

| | Polymer | a1:b1:e1 (Molar Ratio) | Mp | Mn | Mw | PDI |
|---|---|---|---|---|---|---|
| Experimental Example 1-1 | Polymer 1-1 | 53.7:18.3:28.0 | 29,026 | 24,317 | 58,489 | 2.41 |
| Experimental Example 1-2 | Polymer 2-1 | 53.7:18.3:28.0 | 24,859 | 27,213 | 52,131 | 1.91 |
| Experimental Example 1-3 | Polymer 3-1 | 57.0:17.9:25.1 | 24,213 | 25,490 | 57,807 | 2.26 |
| Experimental Example 1-4 | Polymer 4-1 | 57.6:19.4:23.0 | 24,118 | 25,371 | 55,576 | 2.19 |
| Experimental Example 1-5 | Polymer 5-1 | 56.4:17.6:26.0 | 25,433 | 26,227 | 56,016 | 2.13 |
| Experimental Example 1-6 | Polymer 6-1 | 55.7:18.3:26.0 | 24,070 | 24,738 | 53,686 | 2.17 |
| Comparative Example 1-1 | Polymer Q | 53.7:18.3:28.0 | 27,070 | 27,883 | 143,679 | 5.15 |
| Comparative Example 1-2 | Polymer W | 56.4:17.6:26.0 | 24,333 | 25,411 | 57,618 | 2.26 |

Having a larger weight average molecular weight (Mw) represents relatively higher viscosity for the same solvent, which makes manufacture of OLED using micropixels difficult.

In addition, having large molecular weight distribution means distribution of molecules with various molecular weights, which means that reproducible synthesis of a polymer is difficult.

From Table 1, it is identified that Comparative Example 1-1 has larger PDI compared to Experimental Examples 1-1 to 1-6. From this result, it is seen that polymers with various molecular weights are distributed in polymer Q (Comparative Example 1-1). In other words, it is seen that reproducible synthesis of Polymer Q is difficult.

In addition, from Table 1, it is identified that Comparative Example 1-1 has larger Mw compared to Experimental Examples 1-1 to 1-6. Through this, it may be predicted that viscosity of Polymer Q (Comparative Example 1-1) is affected by the high molecular weight when manufacturing an inkjet device, and an organic light emitting device using micropixels may not be readily manufactured.

In short, it is identified from Table 1 that, by the polymer according to one embodiment of the present specification (Examples 1-1 to 1-6) including a tert-butyl group, low molecular weight and low PDI are obtained compared to the polymer including a linear alkyl group (Comparative Example 1-1), and from this, it is seen that a homogeneous polymer may be prepared with the polymer according to one embodiment of the present specification, and the polymer is readily used in an organic light emitting device.

**Experimental Example 2. Measurement of Thin Film Retention Rate**

**Experimental Example 2-1.**

Coating Composition 1 was prepared by dissolving Polymer 1 prepared in Synthesis Example 1 in toluene in a concentration of 2 wt%.

**Comparative Example 2-1.**

Coating Composition 2 was prepared by dissolving the following Compound C-1 prepared in (3) of Synthesis Example 1 in toluene in a concentration of 2 wt%.

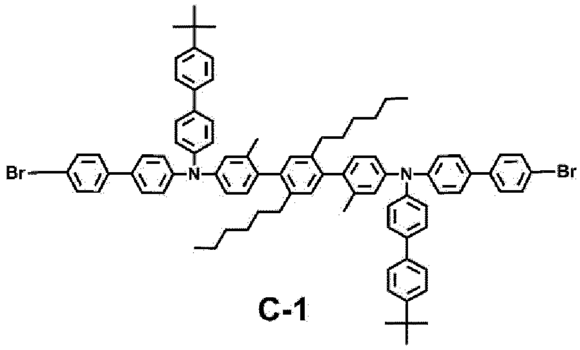

C-1

Coating Compositions 1 and 2 were each spin coated on glass to form a thin film, and UV-vis absorption was measured thereon. This thin film was immersed in cyclohexanone again for 3 minutes, then dried, and UV-vis absorption was measured thereon. A thin film retention rate was identified by comparing sizes of the maximum peaks of UV absorption before and after the immersion.

FIG. 4 is a diagram showing a result of the film retention rate test for the thin film formed with Coating Composition 1.

FIG. 5 is a diagram showing a result of the film retention rate test for the thin film formed with Coating Composition 2.

In FIG. 4 and FIG. 5, (a) shows the UV measurement result immediately after forming the thin film (before immersing in cyclohexane for 3 minutes), and (b) shows the UV measurement result after immersing the thin film in cyclohexanone for 3 minutes.

Through FIG. 4, it is identified that the thin film retention rate is 100% in the thin film formed with Coating Composition 1. In other words, it is identified that the polymer according to one embodiment of the present specification has excellent solvent resistance.

On the other hand, it is identified through FIG. 5 that the film loss ratio is high in the thin film formed with Coating Composition 2. In other words, it is identified that Compound C-1 (monomer) does not have solvent resistance.

**Comparative Example 2-2.**

In order to measure a thin film retention rate of Compound C-1 single polymer, the following polymer was formed and dissolved in a solvent, however, the polymer was not dissolved in the solvent, and the thin film retention rate was not able to be measured.

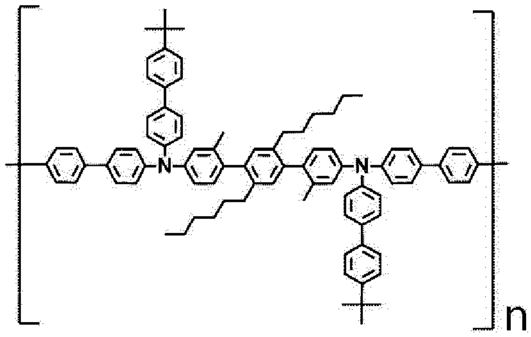

(n: integer of 2 to 10,000)

**Experimental Example 3. Manufacture of Organic Light Emitting Device**

**Experimental Example 3-1.**

**(1) Materials**

A bis(diarylamino)benzofluorene-based compound described in US8,465,848B2 was used as a dopant.

A material described in US7,351,358B2 was used as a HIL. Specifically, a hole injection material prepared

from an aqueous dispersion of electrically conductive polymer and polymeric fluorinated sulfuric acid was used.
A deuterated anthracene compound described in WO2011-028216A1 was used as a host.

**(2) Manufacture of Device**

A glass substrate on which indium tin oxide (ITO) was coated as a thin film to a thickness of 1,500 Å was placed in detergent-dissolved distilled water and ultrasonic cleaned. Herein, a product of Fischer Co. was used as the detergent, and as the distilled water, distilled water filtered twice with a filter manufactured by Millipore Co. was used. After the ITO was cleaned for 30 minutes, ultrasonic cleaning was repeated twice using distilled water for 10 minutes. After the cleaning with distilled water was finished, the substrate was ultrasonic cleaned with solvents of isopropyl alcohol and acetone, then dried, washed for 5 minutes, and then dried.
Cleaned and patterned ITO was treated with UV ozone for 10 minutes immediately before manufacturing a device. After the ozone treatment, the aqueous dispersion of HIL was spin-coated on the ITO surface, and the solvent was removed through heat treatment to form a hole injection layer having a thickness of approximately 40 nm. On the hole injection layer formed above, a toluene solution having Polymer 1-1 prepared in Synthesis Example 1 dissolved in 1.5 wt% was spin-coated, and the solvent was removed through heat treatment to form a hole transfer layer having a thickness of approximately 100 nm. On the hole transfer layer, a methyl benzoate solution having a host and a dopant (host:dopant=93:7 (wt%)) dissolved in a concentration of 2.0 wt% was spin-coated to form a light emitting layer having a thickness of approximately 100 nm. After that, the result was transferred to a vacuum deposition apparatus, and BCP was vacuum deposited on the light emitting layer to a thickness of 35 nm to form an electron injection and transfer layer. On the electron injection and transfer layer, LiF and aluminum were deposited to thicknesses of 1 nm and 100 nm, respectively, to form a cathode.
In the above-mentioned process, the deposition rates of the lithium fluoride (LiF) and the aluminum of the cathode were maintained at 0.3 Å/sec and 2 Å/sec, respectively, and the degree of vacuum during the deposition was maintained at $5\times10^{-8}$ torr to $2\times10^{-7}$ torr.

**Experimental Example 3-2.**

An organic light emitting device was manufactured in the same manner as in Example 1 except that Polymer 2-1 was used instead of Polymer 1-1 in Example 1.

**Experimental Example 3-3.**

An organic light emitting device was manufactured in the same manner as in Example 1 except that Polymer 3-1 was used instead of Polymer 1-1 in Example 1.

**Experimental Example 3-4.**

An organic light emitting device was manufactured in the same manner as in Example 1 except that Polymer 4-1 was used instead of Polymer 1-1 in Example 1.

**Experimental Example 3-5.**

An organic light emitting device was manufactured in the same manner as in Example 1 except that Polymer 5-1 was used instead of Polymer 1-1 in Example 1.

**Experimental Example 3-6.**

An organic light emitting device was manufactured in the same manner as in Example 1 except that Polymer 6-1 was used instead of Polymer 1-1 in Example 1.

**Comparative Example 3-1.**

An organic light emitting device was manufactured in the same manner as in Experimental Example 3-1 except that Polymer Q prepared in Comparative Synthesis Example 1 was used instead of Polymer 1 in Example 1.

**Comparative Example 3-2.**

An organic light emitting device was manufactured in the same manner as in Experimental Example 3-1 except that Polymer W prepared in Comparative Synthesis Example 2 was used instead of Polymer 1 in Example 1.

For each of the organic light emitting devices manufactured in Experimental Examples 3-1 to 3-6, and Comparative Examples 3-1 and 3-2, driving voltage, light emission efficiency, power efficiency, external quantum efficiency, luminance, color coordinate and CE/CIEy at current density of 10 mA/$cm^2$ are shown in the following Table 2. The external quantum efficiency was obtained by (the number of emitted photons)/(the number of injected charge carriers), and the color coordinate is x and y coordinates according to the C.I.E chromaticity diagram (Commission Internationale de L'Eclairage, 1931), and CE/CIEy is a value obtained by dividing light emission efficiency (cd/A) by the color coordinate (y) value.

[Table 2]

| | Hole Transfer Layer | Driving Voltage (V) | Light Emission Efficien cy (cd/A) | Power Efficien cy (lm/W) | External Quantum Efficien cy (QE) (%) | Lumina nce (cd/$m^2$ ) | Color Coord inate (x) | Color Coord inate (Y) | CE/C IEy |
|---|---|---|---|---|---|---|---|---|---|
| Experi mental Example 3-1 | Polymer 1-1 | 5.32 | 4.87 | 2.87 | 6.12 | 486.50 | 0.140 | 0.097 | 49.9 2 |
| Experi mental Example 3-2 | Polymer 2-1 | 5.25 | 4.74 | 2.83 | 6.07 | 473.76 | 0.141 | 0.095 | 50.1 1 |
| Experi mental Example 3-3 | Polymer 3-1 | 5.18 | 4.72 | 2.87 | 6.00 | 472.35 | 0.141 | 0.096 | 49.2 7 |
| Experi mental Example 3-4 | Polymer 4-1 | 5.20 | 4.70 | 2.84 | 6.02 | 469.84 | 0.141 | 0.095 | 49.7 0 |
| Experi mental Example 3-5 | Polymer 5-1 | 4.86 | 4.51 | 2.92 | 6.75 | 1000.0 0 | 0.134 | 0.081 | 55.7 7 |
| Experi mental Example 3-6 | Polymer 6-1 | 5.03 | 4.49 | 2.81 | 6.69 | 1000.0 0 | 0.135 | 0.081 | 55.3 1 |
| Compara tive Example 3-1 | Polymer Q | 7.81 | 1.21 | 0.49 | 1.41 | 121.05 | 0.150 | 0.107 | 11.3 1 |
| Compara tive Example 3-2 | Polymer W | 7.23 | 4.34 | 1.89 | 4.82 | 434.13 | 0.139 | 0.117 | 36.9 9 |

From Table 2, it is identified that Experimental Examples 3-1 to 3-6 have low driving voltage and excellent efficiency compared to Comparative Example 3-1.

When comprehensively considering these results with Table 1, it is identified that the polymer according to one

embodiment of the present specification has low driving voltage and excellent efficiency when used in an organic light emitting device (Experimental Examples 3-1 to 3-6) despite the low molecular weight. Through this, it is identified that a homogeneous polymer may be prepared by the polymer according to one embodiment of the present specification including a tert-butyl group, and accordingly, superior performance is obtained when used in a device.

In addition, from Table 2, it is identified that Experimental Examples 3-1 to 3-6 have low driving voltage and excellent efficiency compared to Comparative Example 3-2.

Through this, it is identified that, when the unit of Chemical Formula 2 included in the polymer according to one embodiment of the present specification includes N instead of a tert-butyl group (Comparative Example 3-2), the energy level of the applied layer changes (HOMO energy level increases), and high driving voltage and low efficiency are obtained compared to when the unit of Chemical Formula 2 includes a tert-butyl group (Experimental Examples 3-1 to 3-6).

Hereinbefore, preferred embodiments (hole transfer layer) of the present disclosure have been described, however, the present disclosure is not limited thereto, and various modifications may be made within the scope of the claims and the detailed descriptions, and these also fall within the category of the disclosure.

## Claims

**1.** A polymer represented by the following Chemical Formula 1:

[Chemical Formula 1] $E1\text{-}[A]_a\text{-}[B]_b\text{-}[C]_c\text{-}E2$

wherein, in Chemical Formula 1,

A is represented by the following Chemical Formula 2;
B is represented by the following Chemical Formula 3;
C is a substituted or unsubstituted arylene group; or a substituted or unsubstituted divalent heterocyclic group;
E1 and E2 are the same as or different from each other, and each independently hydrogen; deuterium; a substituted or unsubstituted alkyl group; a substituted or unsubstituted silyl group; a substituted or unsubstituted aryl group; a substituted or unsubstituted arylamine group; a substituted or unsubstituted siloxane group; a crosslinking group; or a combination thereof,
a, b and c are each a mole fraction;
a is a real number of $0<a\leq1$;
b is a real number of $0\leq b<1$;
c is a real number of $0\leq c<1$; and
a+b+c is 1,

[Chemical Formula 2]

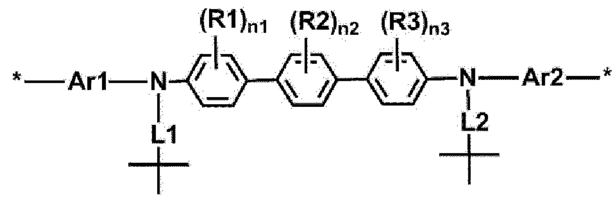

in Chemical Formula 2,
Ar1, Ar2, L1 and L2 are the same as or different from each other, and each independently a substituted or unsubstituted arylene group;
R1 to R3 are the same as or different from each other, and each independently hydrogen; deuterium; a halogen group; a substituted or unsubstituted alkyl group; a substituted or unsubstituted silyl group; a substituted or unsubstituted aryl group; a substituted or unsubstituted heterocyclic group; a substituted or unsubstituted arylamine group; or a substituted or unsubstituted siloxane group;
n1 to n3 are each an integer of 1 to 4;
when n1 to n3 are each 2 or greater, substituents in each parenthesis are the same as or different from each other; and
* is a point of attachment in the polymer,

[Chemical Formula 3]

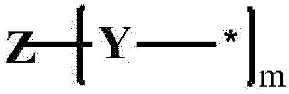

in Chemical Formula 3,
m is an integer of 3 or 4;
when m is 3, Z is CRa; SiRa; N; or a trivalent substituted or unsubstituted aryl group;
when m is 4, Z is C; Si; or a tetravalent substituted or unsubstituted aryl group;
Ra is hydrogen; a substituted or unsubstituted alkyl group; or a substituted or unsubstituted aryl group;
Y is a direct bond; a substituted or unsubstituted alkylene group; or a substituted or unsubstituted arylene group;
when Y is a direct bond; or a substituted or unsubstituted alkylene group, Z is a trivalent or tetravalent substituted or unsubstituted aryl group; and
* is a point of attachment in the polymer.

**2.** The polymer of Claim 1, wherein E1 and E2 are the same as or different from each other, and each independently a substituted or unsubstituted alkyl group; a substituted or unsubstituted aryl group; a crosslinking group; or a combination thereof.

**3.** A polymer comprising:

a unit represented by the following Chemical Formula 2; and
an end group represented by the following Chemical Formula 5:

[Chemical Formula 2]

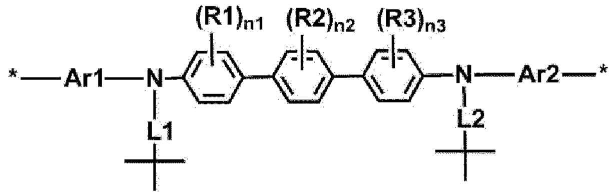

[Chemical Formula 5] *-[E]

wherein, in Chemical Formulae 2 and 5,
Ar1, Ar2, L1 and L2 are the same as or different from each other, and each independently a substituted or unsubstituted arylene group;
R1 to R3 are the same as or different from each other, and each independently hydrogen; deuterium; a halogen group; a substituted or unsubstituted alkyl group; a substituted or unsubstituted silyl group; a substituted or unsubstituted aryl group; a substituted or unsubstituted heterocyclic group; a substituted or unsubstituted arylamine group; or a substituted or unsubstituted siloxane group;
n1 to n3 are each an integer of 1 to 4;
when n1 to n3 are each 2 or greater, substituents in each parenthesis are the same as or different from each other;
E is hydrogen; deuterium; a substituted or unsubstituted alkyl group; a substituted or unsubstituted silyl group; a substituted or unsubstituted aryl group; a substituted or unsubstituted arylamine group; a substituted or unsubstituted siloxane group; a crosslinking group; or a combination thereof; and
* is a point of attachment in the polymer.

**4.** The polymer of Claim 3, further comprising a unit represented by the following Chemical Formula 3:

[Chemical Formula 3]

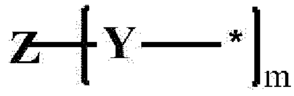

wherein, in Chemical Formula 3,

m is an integer of 3 or 4;
when m is 3, Z is CRa; SiRa; N; or a trivalent substituted or unsubstituted aryl group;
when m is 4, Z is C; Si; or a tetravalent substituted or unsubstituted aryl group;
Ra is hydrogen; a substituted or unsubstituted alkyl group; or a substituted or unsubstituted aryl group;
Y is a direct bond; a substituted or unsubstituted alkylene group; or a substituted or unsubstituted arylene group;
when Y is a direct bond; or a substituted or unsubstituted alkylene group, Z is a trivalent or tetravalent substituted or unsubstituted aryl group; and
* is a point of attachment in the polymer.

**5.** The polymer of Claim 3, further comprising a unit represented by the following Chemical Formula 4:

[Chemical Formula 4] *-[C]-*

wherein, in Chemical Formula 4,

C is a substituted or unsubstituted arylene group; or a substituted or unsubstituted divalent heterocyclic group; and
* is a point of attachment in the polymer.

**6.** The polymer of any one of Claims 1 to 5, wherein Chemical Formula 2 is represented by the following Chemical Formula 2-1:

[Chemical Formula 2-1]

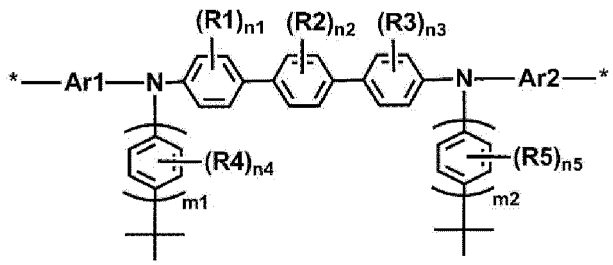

in Chemical Formula 2-1,

R1 to R3, Ar1, Ar2 and n1 to n3 have the same definitions as in Chemical Formula 2;
R4 and R5 are the same as or different from each other, and each independently hydrogen; deuterium; a halogen group; or a substituted or unsubstituted alkyl group;
m1 and m2 are each an integer of 1 to 3;
when m1 and m2 are each 2 or greater, structures in each parenthesis are the same as or different from each other;
n4 and n5 are each an integer of 1 to 4;
when n4 and n5 are each 2 or greater, substituents in each parenthesis are the same as or different from each other; and
* is a point of attachment in the polymer.

**7.** The polymer of any one of Claims 1, 2 and 4, wherein Chemical Formula 3 is represented by any one of the following Chemical Formulae 3-1 to 3-4:

[Chemical Formula 3-1]

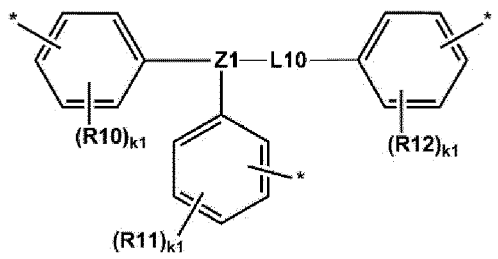

[Chemical Formula 3-2]

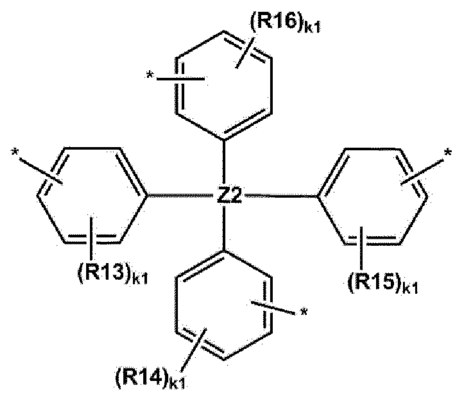

[Chemical Formula 3-3]

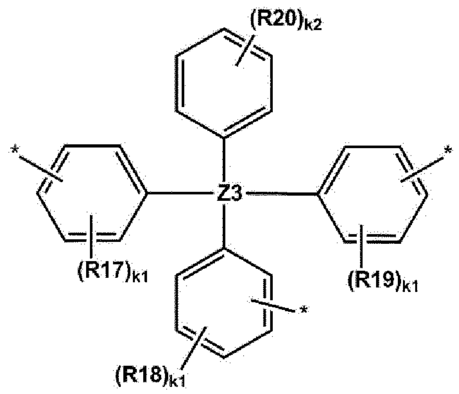

[Chemical Formula 3-4]

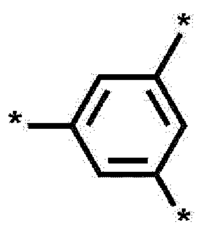

in Chemical Formulae 3-1 to 3-4,

Z1 is CRa; SiRa; N; or a trivalent substituted or unsubstituted aryl group;
Z2 and Z3 are the same as or different from each other, and each independently C; Si; or a tetravalent substituted

or unsubstituted aryl group;
L10 is a direct bond; or a substituted or unsubstituted arylene group;
Ra is hydrogen; a substituted or unsubstituted alkyl group; or a substituted or unsubstituted aryl group;
R10 to R20 are the same as or different from each other, and each independently hydrogen; deuterium; a halogen group; a cyano group; an alkoxy group; an aryloxy group; a fluoroalkoxy group; a siloxane group; a substituted or unsubstituted amine group; a substituted or unsubstituted alkyl group; a substituted or unsubstituted aryl group; a substituted or unsubstituted heterocyclic group; or a crosslinking group, and adjacent groups may bond to each other to form a ring;
k1 is an integer of 1 to 4;
k2 is an integer of 1 to 5;
when k1 is 2 or greater, substituents in the parentheses are the same as or different from each other;
when k2 is 2 or greater, substituents in the parentheses are the same as or different from each other; and
* is a point of attachment in the polymer.

**8.** The polymer of any one of Claims 1 to 5, which has a weight average molecular weight of 30,000 g/mol to 100,000 g/mol.

**9.** An organic light emitting device comprising:

a first electrode;
a second electrode; and
one or more organic material layers provided between the first electrode and the second electrode,
wherein one or more layers of the organic material layers include the polymer of any one of Claims 1 to 5.

**10.** The organic light emitting device of Claim 9, wherein the organic material layer including the polymer is a hole injection layer, a hole transfer layer, or a layer carrying out hole injection and hole transfer at the same time.

【FIG. 1】

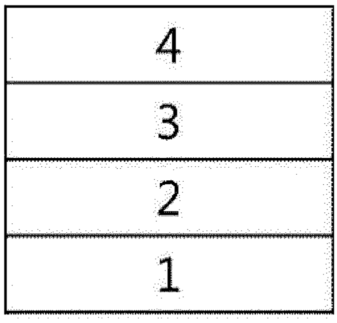


【FIG. 2】

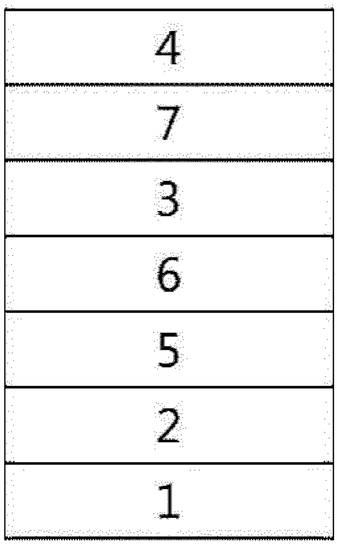


【FIG. 3】

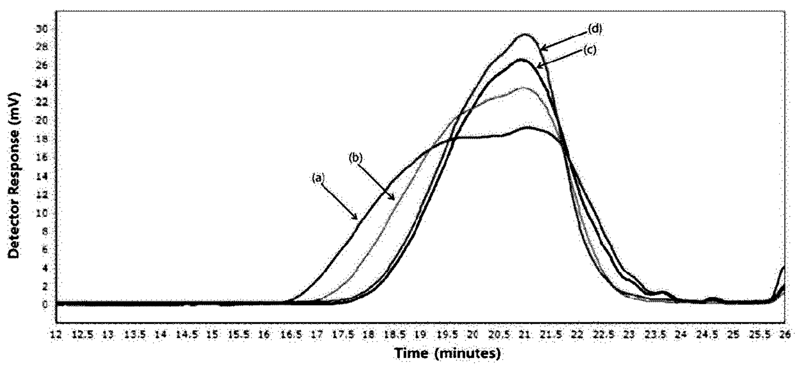

【FIG. 4】

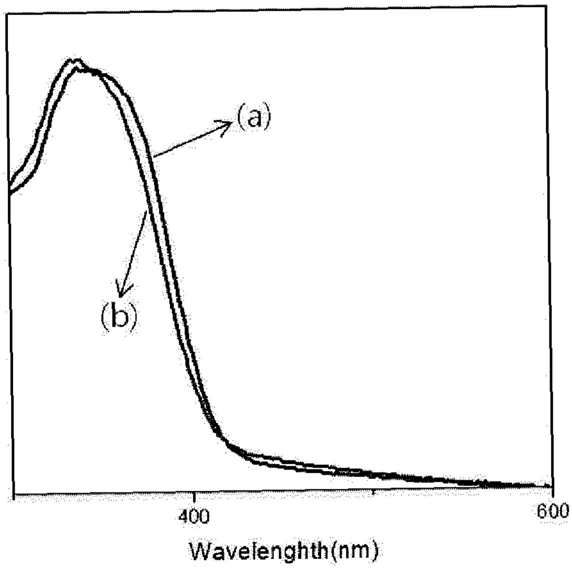


【FIG. 5】

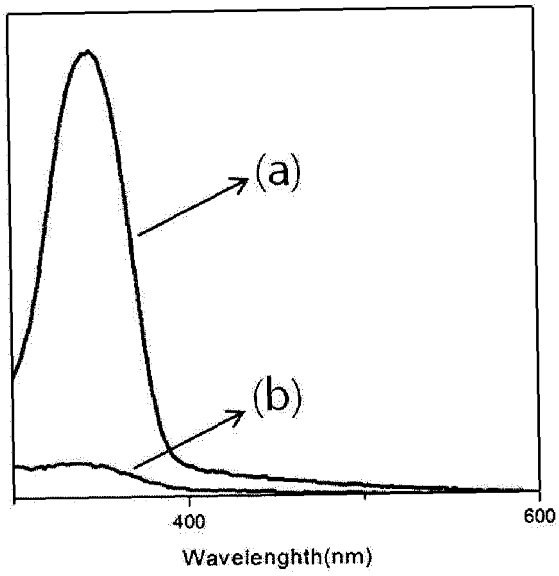

**INTERNATIONAL SEARCH REPORT**

International application No.
**PCT/KR2021/011754**

**A. CLASSIFICATION OF SUBJECT MATTER**

**C08G 61/12**(2006.01)i; **H01L 51/50**(2006.01)i; **H01L 51/52**(2006.01)i

According to International Patent Classification (IPC) or to both national classification and IPC

**B. FIELDS SEARCHED**

Minimum documentation searched (classification system followed by classification symbols)

C08G 61/12(2006.01); C07C 211/54(2006.01); C07C 211/55(2006.01); C07D 411/10(2006.01); C07D 411/12(2006.01); C08B 5/08(2006.01); C08G 61/02(2006.01); C09K 11/06(2006.01); H01L 51/50(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal), STN (Registry, Caplus), Google & keywords: 유기발광소자(OLED, organic light emitting device, organic electroluminescence), 중합체(polymer), 아민(amine), 정공 주입층(HIL, hole inject layer), 정공 수송층(HTL, hole transfer layer, hole transport layer)

**C. DOCUMENTS CONSIDERED TO BE RELEVANT**

| Category* | Citation of document, with indication, where appropriate, of the relevant passages | Relevant to claim No. |
|---|---|---|
| X | KR 10-2016-0131947 A (E.I. DU PONT DE NEMOURS AND COMPANY) 16 November 2016 (2016-11-16)<br>See claims 1-19; and paragraphs [0091], [0179]-[0194], [0223]-[0226], [0271]-[0287], [0328]-[0381], [0493] and [0494]. | 1-10 |
| A | KR 10-2013-0021446 A (E.I. DU PONT DE NEMOURS AND COMPANY) 05 March 2013 (2013-03-05)<br>See claims 1-16. | 1-10 |
| A | WO 2019-105327 A1 (GUANGZHOU CHINARAY OPTOELECTRONIC MATERIALS LTD.) 06 June 2019 (2019-06-06)<br>See pages 9 and 10. | 1-10 |
| A | WO 2015-089027 A1 (E. I. DU PONT DE NEMOURS AND COMPANY) 18 June 2015 (2015-06-18)<br>See claims 1-6. | 1-10 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **27 December 2021** | **27 December 2021** |

Name and mailing address of the ISA/KR

**Korean Intellectual Property Office**
**Government Complex-Daejeon Building 4, 189 Cheongsa-ro, Seo-gu, Daejeon 35208**

Facsimile No. **+82-42-481-8578**

Authorized officer

Telephone No.

Form PCT/ISA/210 (second sheet) (July 2019)

INTERNATIONAL SEARCH REPORT

International application No.
PCT/KR2021/011754

C. DOCUMENTS CONSIDERED TO BE RELEVANT

| Category* | Citation of document, with indication, where appropriate, of the relevant passages | Relevant to claim No. |
|---|---|---|
| A | KR 10-2007-0120876 A (FUJI XEROX CO., LTD.) 26 December 2007 (2007-12-26)<br>See claims 1-23. | 1-10 |

Form PCT/ISA/210 (second sheet) (July 2019)

**INTERNATIONAL SEARCH REPORT**
**Information on patent family members**

International application No.
**PCT/KR2021/011754**

| Patent document cited in search report | Publication date (day/month/year) | Patent family member(s) | Publication date (day/month/year) |
|---|---|---|---|
| KR 10-2016-0131947 A | 16 November 2016 | CN 106117522 A | 16 November 2016 |
| | | CN 106117522 B | 30 April 2019 |
| | | CN 107108861 A | 29 August 2017 |
| | | CN 107108861 B | 12 November 2019 |
| | | CN 108349869 A | 31 July 2018 |
| | | JP 2019-501872 A | 24 January 2019 |
| | | KR 10-2017-0088382 A | 01 August 2017 |
| | | KR 10-2018-0066115 A | 18 June 2018 |
| | | KR 10-2020-0140232 A | 15 December 2020 |
| | | KR 10-2021-0019132 A | 19 February 2021 |
| | | KR 10-2191572 B1 | 15 December 2020 |
| | | KR 10-2217267 B1 | 17 February 2021 |
| | | KR 10-2251403 B1 | 11 May 2021 |
| | | US 10439140 B2 | 08 October 2019 |
| | | US 10749111 B2 | 18 August 2020 |
| | | US 10879467 B2 | 29 December 2020 |
| | | US 2016-0329497 A1 | 10 November 2016 |
| | | US 2017-0358750 A1 | 14 December 2017 |
| | | US 2018-0287067 A1 | 04 October 2018 |
| | | US 2019-348607 A1 | 14 November 2019 |
| | | US 9954174 B2 | 24 April 2018 |
| | | WO 2016-081583 A1 | 26 May 2016 |
| | | WO 2017-079042 A1 | 11 May 2017 |
| KR 10-2013-0021446 A | 05 March 2013 | EP 2582658 A1 | 24 April 2013 |
| | | JP 2013-531658 A | 08 August 2013 |
| | | JP 5893011 B2 | 23 March 2016 |
| | | KR 10-1755067 B1 | 06 July 2017 |
| | | TW 201204687 A | 01 February 2012 |
| | | US 10199577 B2 | 05 February 2019 |
| | | US 2013-0082251 A1 | 04 April 2013 |
| | | US 2017-0040539 A1 | 09 February 2017 |
| | | US 9515267 B2 | 06 December 2016 |
| | | WO 2011-159872 A1 | 22 December 2011 |
| WO 2019-105327 A1 | 06 June 2019 | CN 108003365 A | 08 May 2018 |
| | | CN 108003365 B | 22 March 2019 |
| WO 2015-089027 A1 | 18 June 2015 | US 10586929 B2 | 10 March 2020 |
| | | US 2016-0308141 A1 | 20 October 2016 |
| KR 10-2007-0120876 A | 26 December 2007 | JP 2008-004636 A | 10 January 2008 |
| | | JP 2008-004637 A | 10 January 2008 |
| | | KR 10-0858458 B1 | 16 September 2008 |
| | | US 2007-0292681 A1 | 20 December 2007 |

Form PCT/ISA/210 (patent family annex) (July 2019)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- KR 1020210026474
- US 8465848 B2
- US 7351358 B2
- WO 2011028216 A1